Europäisches Patentamt

European Patent Office

Office européen des brevets

(19)

(11) **EP 1 338 674 A1**

(12) **EUROPEAN PATENT APPLICATION**

(43) Date of publication:
**27.08.2003 Bulletin 2003/35**

(51) Int Cl.7: **C23C 16/14**, C23C 16/448,
C23C 16/52

(21) Application number: **03002047.3**

(22) Date of filing: **29.01.2003**

(84) Designated Contracting States:
**AT BE BG CH CY CZ DE DK EE ES FI FR GB GR
HU IE IT LI LU MC NL PT SE SI SK TR**
Designated Extension States:
**AL LT LV MK RO**

(30) Priority: **05.02.2002 JP 2002027727
05.02.2002 JP 2002027733**

(71) Applicant: **Mitsubishi Heavy Industries, Ltd.
Tokyo (JP)**

(72) Inventors:
• Sakamoto, Hitoshi, Mitsubishi Heavy Ind., Ltd.
  Kanazawa-ku, Yokohama-shi, Kanagawa (JP)
• Yahata, Naoki, Mitsubishi Heavy Ind., Ltd.
  Kanazawa-ku, Yokohama-shi, Kanagawa (JP)
• Ooba, Yoshiyuki, Mitsubishi Heavy Ind., Ltd.
  Kanazawa-ku, Yokohama-shi, Kanagawa (JP)

(74) Representative: **HOFFMANN - EITLE
Patent- und Rechtsanwälte
Arabellastrasse 4
81925 München (DE)**

(54) **Metal film production apparatus and method**

(57)     A metal film production apparatus and method supply a source gas containing chlorine, as a halogen, to the interior of a chamber such that the source gas is intermittently supplied, to form a Cu component of a precursor into a film on a substrate, while suppressing a relative increase in etching particles. Thus, the source gas is supplied in the full presence of plasma particles contributing to film formation. Moreover, the source gas is supplied in a state in which a Cu film formed is not etched with the etching particles. Consequently, the Cu film is reliably increased with respect to the film formation time to increase the film formation speed.

    Alternatively, the apparatus and method supply a source gas to the interior of a chamber between a substrate and a copper plate member such that the source gas is gradually increased continuously from a flow rate of 0 to a predetermined flow rate to increase the particle size of the metal component (Cu component) gradually, and form the Cu component of a precursor into a film on the substrate, while gradually increasing particles of the precursor, thereby preparing a Cu film with high adhesion on the surface of the substrate and stabilizing a metal wiring process.

**FIG. 1**

EP 1 338 674 A1

## Description

The entire disclosure of Japanese Patent Application Nos. 2002-027727 and 2002-027733 both filed on February 5, 2002 including specification, claims, drawings and summary is incorporated herein by reference in its entirety.

## BACKGROUND OF THE INVENTION

### 1. Field of the Invention

This invention relates to a metal film production apparatus and a metal film production method which produce a metal film on the surface of a substrate by vapor phase deposition.

### 2. Description of the Related Art

In producing a metal film, for example, a thin film of copper, by vapor phase deposition, it has been common practice to use an organometallic complex of a liquid, for example, copper-hexafluoroacetylacetonato-trimethylvinylsilane, as a starting material, dissolve the solid starting material in a solvent, and vaporize the solution by use of a thermal reaction to form a film on a substrate.

With the above-mentioned earlier technology, it has been difficult to increase the speed of film formation, because the film is formed with the use of a thermal reaction. Moreover, the metal complex as the starting material is expensive. In addition, hexafluoroacetylacetonato and trimethylvinylsilane accompanying copper remain as impurities in the thin film of copper, making it difficult to improve the quality of the film.

## SUMMARY OF THE INVENTION

The present invention has been accomplished in the light of the above circumstances. It is an object of the invention to provide a metal film production apparatus and a metal film production method which have a high film formation speed, which can use an inexpensive starting material, and which can produce a metal film with satisfactory adhesion and without involving impurities remaining in the film. It is another object of the invention to provide a metal film production apparatus and a metal film production method which have a high film formation speed for a substrate having a wiring trench or the like provided therein, which can use an inexpensive starting material, and which can produce a metal film with satisfactory adhesion and high burial characteristics without involving impurities remaining in the film.

According to the present invention, there is provided a metal film production apparatus comprising: a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for suppressing a relative increase in etching particles by supplying the source gas intermittently. Thus, the source gas can be supplied in the full presence of plasma particles contributing to film formation. Moreover, the source gas can be supplied in a state in which the metal film formed is not etched with etching particles. Consequently, the metal film can be reliably increased with respect to the film formation time to increase the film formation speed. As a result, it is possible to construct a metal film production apparatus which has a high film formation speed, which can use an inexpensive starting material, and which can produce a metal film with satisfactory adhesion without involving impurities remaining in the film.

There may be further included rare gas supply means for supplying a rare gas to generate a rare gas plasma, and the control means may have the function of adjusting the amount of the rare gas according to supply of the source gas. Thus, the source gas can be intermittently supplied in a stable plasma condition, with the amount of gases being maintained.

The metal film production apparatus may further include detection means for detecting plasma particles within the chamber, and the control means may have the function of controlling a supply state of the source gas based on the situation of the plasma particles detected by the detection means. Thus, the situation of plasma particles contributing to film formation can be accurately grasped to increase the film formation speed.

The control means may have the function of controlling the source gas so as to be intermittently supplied in a preset state. Thus, the film formation speed can be increased by a simple construction.

As the preset state in the control means, t/T, the relation between the period of time T for which the source gas is supplied, and the period of time t for which the source gas is not supplied, may be set as follows

$$0.03 \leq t/T \leq 0.10$$

Thus, the source gas can be controlled to be intermittently supplied unerringly.

The control means may be means for intermittently controlling supply of the source gas from the source gas supply means. Alternatively, the control means may be means for controlling supply of the source gas so as to be in an intermittently supplied manner by controlling the situation of exhaust from within the chamber. The source gas containing the halogen may be the source gas containing chlorine. The etched member may be made of copper so that $Cu_xCl_y$ is formed as the precursor. Alternatively, the etched member may be made of tantalum, tungsten or titanium which is a halide-forming metal.

According to the present invention, there is also provided a metal film production method comprising: supplying a source gas containing a halogen to an interior of a chamber between a substrate and a metallic etched member such that the source gas is intermittently supplied to suppress a relative increase in etching particles; converting an atmosphere within the chamber into a plasma to generate a source gas plasma so that the etched member is etched with the source gas plasma to form a precursor from a metal component contained in the etched member and the source gas; and making a temperature of the substrate lower than a temperature of the etched member to form the metal component of the precursor into a film on the substrate, while suppressing the relative increase in the etching particles. Thus, the source gas can be supplied in the full presence of plasma particles contributing to film formation. Moreover, the source gas can be supplied in a state in which the metal film formed is not etched with etching particles. Consequently, the metal film can be reliably increased with respect to the film formation time to increase the film formation speed. As a result, it is possible to construct a metal film production method which has a high film formation speed, which can use an inexpensive starting material, and which can produce a metal film with satisfactory adhesion without involving impurities remaining in the film.

The metal film production method may further comprise: detecting plasma particles within the chamber; and controlling a supply state of the source gas based on a situation of the detected plasma particles to suppress the relative increase in the etching particles. Thus, the situation of plasma particles contributing to film formation can be accurately grasped to increase the film formation speed.

The metal film production method may further comprise: bringing the source gas into an unsupplied state when the plasma particles contributing to film formation begin to decrease after maximizing; and bringing the source gas into a supplied state when the etching particles come into a predetermined decreased state. Thus, the situation of plasma particles contributing to film formation can be accurately grasped to increase the film formation speed.

The metal film production method may further control the source gas so as to be intermittently supplied in a preset state, thereby suppressing the relative increase in the etching particles. Thus, the film formation speed can be increased by a simple construction.

Also, t/T, the relation between the period of time T for which the source gas is supplied, and the period of time t for which the source gas is not supplied, may be set as follows:

$$0.03 \leq t/T \leq 0.10$$

Thus, the source gas can be controlled to be intermittently supplied unerringly.

In the metal film production method, the source gas containing the halogen may be the source gas containing chlorine. The etched member may be made of copper so that $Cu_xCl_y$ is formed as the precursor. The etched member may be made of tantalum, tungsten or titanium which is a halide-forming metal.

According to the present invention, there is also provided a metal film production apparatus comprising: a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for gradually increasing the source gas from a flow rate of 0 to a predetermined flow rate during film formation, thereby gradually increasing a particle size of the metal component. Thus, immediately after start of film formation, the metal component with a small particle size is formed into a film. Then, the particle size of the metal component is gradually increased to a predetermined value, so that a metal film with high adhesion can be prepared. As a result, it is possible to construct a metal film production apparatus which has a high film formation speed, which can use an inexpensive starting material, and which can produce a metal film with satisfactory adhesion without involving impurities remaining in the film.

The control means may have the function of gradually increasing the source gas continuously. Thus, the particle size of the metal component can be increased reliably from a small value to a large value.

There may be rare gas supply means for supplying a rare gas at a predetermined flow rate at start of film formation to generate a rare gas plasma, and the control means may have the function of gradually decreasing the amount of the rare gas in accordance with a gradual increase in the source gas in gradually increasing the amount of the source gas. Thus, the source gas can be gradually increased in a stable plasma state.

The control means may have the changing function of changing an increasing function according to a material for the substrate and the metal component formed into the film. Thus, the particle size of the metal component can be optimized to suit the material.

According to the present invention, there is also provided a metal film production apparatus comprising: a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for increasing the source gas to a predetermined flow rate in multiple stages during film formation, thereby increasing a particle size of the metal component stepwise. Thus, even if the substrate has a trench or the like, the metal component is formed into a film within the trench immediately after film formation. Then, the particle size of the metal component is increased to a predetermined value, so that a metal film with high burial characteristics can be prepared. Consequently, it is possible to construct a metal film production apparatus which has a high film formation speed for a substrate having a wiring trench or the like provided therein, which can use an inexpensive starting material, and which can produce a metal film with satisfactory adhesion and burial characteristics without involving impurities remaining in the film.

There may be rare gas supply means for supplying a rare gas at a predetermined flow rate at start of film formation to generate a rare gas plasma, and the control means may have the function of decreasing an amount of the rare gas in multiple stages in accordance with an increase in the source gas in increasing an amount of the source gas in the multiple stages. Thus, the source gas can be increased to a predetermined flow rate in multiple stages, with a plasma state being stable.

The substrate accommodated in the chamber may be provided with a trench for wiring formation, and the control means may have the function of supplying the source gas in such an amount that particles of the metal component are stacked in layers within the trench, and then increasing the amount of the source gas. Thus, burial characteristics for the wiring formation trench can be improved.

According to the present invention, there is also provided a metal film production apparatus comprising: a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for increasing the source gas to a predetermined flow rate in multiple stages during film formation, thereby increasing a particle size of the metal component stepwise, and for gradually increasing the source gas at start of each increase, thereby gradually increasing the particle size of the metal component. Thus, even if the substrate has a trench or the like, the metal component is formed into a film within the trench immediately after film formation. Then, the particle size of the metal component is increased to a predetermined value. Moreover, immediately after start of film formation, the metal component with a small particle size is formed into a film. Then, the particle size of the metal component is gradually increased to a predetermined size. As a result, a metal film with high burial characteristics and high adhesion can be prepared. Consequently, it is possible to construct a metal film production apparatus which has a high film formation speed for a substrate having a wiring trench or the like provided therein, which can use an inexpensive starting material, and which can produce a metal film with satisfactory adhesion and burial characteristics without involving impurities remaining in the film.

According to the present invention, there is also provided a metal film production apparatus comprising: a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for gradually increasing the source gas to a predetermined flow rate during film formation, thereby gradually increasing a particle size of the metal component, and for intermittently supplying the source gas, thereby suppressing a relative increase in etching particles. Thus, immediately after start of film formation, the metal component with a small particle size is formed into a film. Then, the particle size of the metal component is gradually increased to a predetermined size. Moreover, a relative increase in etching particles is suppressed. As a result, a metal film can be produced with high adhesion and with improvement in the film formation speed. Consequently, it is possible to construct a metal film production apparatus which has a high film formation speed, which can use an inexpensive starting material, and which can produce a metal film with satisfactory adhesion without involving impurities remaining in the film.

According to the present invention, there is also provided a metal film production apparatus comprising: a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for increasing the source gas to a predetermined flow rate in multiple stages during film formation, thereby increasing a particle size of the metal component stepwise, also for gradually increasing the source gas at start of increase, thereby gradually increasing the particle size of the metal component, and further for intermittently supplying the source gas, thereby suppressing a relative increase in etching particles. Thus, even if the substrate has a trench or the like, the metal component is formed into a film within the trench immediately after film formation. Then, the particle size of the metal component is increased to a predetermined value. Moreover, immediately after start of film formation, the metal component with a small particle size is formed into a film. Then, the particle size of the metal component is gradually increased to a predetermined size. Moreover, a relative increase in etching particles is suppressed. As a result, a metal film can be prepared with high burial characteristics and high adhesion and with the film formation speed being increased. Consequently, it is possible to construct a metal film production apparatus which has a high film formation speed, which can use an inexpensive starting material, and which can produce a metal film with satisfactory adhesion and burial characteristics without involving impurities remaining in the film.

In the metal film production apparatus, the source gas containing the halogen may be the source gas containing chlorine. The etched member may be made of copper so that $Cu_xCl_y$ is formed as the precursor. Alternatively, the etched member may be made of tantalum, tungsten or titanium which is a halide-forming metal.

According to the present invention, there is provided a metal film production method comprising: supplying a source gas containing a halogen to an interior of a chamber between a substrate and a metallic etched member such that the source gas is gradually increased from a flow rate of 0 to a predetermined flow rate to increase a particle size of a metal component gradually; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while gradually increasing the particle size of the metal component. Thus, immediately after start of film formation, the metal component with a small particle size is formed into a film. Then, the particle size of the metal component is gradually increased to a predetermined size. As a result, a metal film with high adhesion can be prepared. Consequently, it is possible to construct a metal film production method which has a high film formation speed, which can use an inexpensive starting material, and which can produce a metal film with satisfactory adhesion without involving impurities remaining in the film.

According to the present invention, there is also provided a metal film production method comprising: supplying a source gas containing a halogen to an interior of a chamber between a substrate and a metallic etched member such that the source gas is increased to a predetermined flow rate in multiple stages to increase a particle size of a metal component stepwise; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while increasing the particle size of the metal component stepwise. Thus, even if the substrate has a trench or the like, the metal component is formed into a film within the trench immediately after film formation. Then, the particle size of the metal component is increased to a predetermined value. As a result, a metal film with high burial characteristics can be prepared. Consequently, it is possible to construct a metal film production method which has a high film formation speed even for a substrate having a wiring trench or the like provided therein, which can use an inexpensive starting material, and which can produce a metal film with satisfactory adhesion and burial characteristics without involving impurities remaining in the film.

When the source gas is increased to the predetermined flow rate in the multiple stages, the source gas may be supplied in such an amount that particles of the metal component are stacked in layers within a trench for wiring formation provided in the substrate, and then the amount of the source gas may be increased. Thus, burial characteristics can be enhanced for the wiring formation trench.

According to the present invention, there is also provided a metal film production method comprising: supplying a source gas containing a halogen to an interior of a chamber between a substrate and a metallic etched member such that the source gas is increased to a predetermined flow rate in multiple stages to increase a particle size of a metal component stepwise, and such that the source gas is gradually increased at start of each increase to increase the particle size of the metal component gradually; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while increasing the particle size stepwise, and also increasing the particle size gradually. Thus, even if the substrate has a trench or the like, the metal component is formed into a film within the trench immediately after film formation. Then, the particle size of the metal component is increased to a predetermined value. Moreover, immediately after start of film formation, the metal component with a small particle size is formed into a film. Then, the particle size of the metal component is gradually increased to a predetermined size. As a result, a metal film can be prepared with high burial characteristics and high adhesion. Consequently, it is possible to construct a metal film production method which has a high film formation speed for a substrate having a wiring trench or the like provided therein, which can use an inexpensive starting material, and which can produce a metal film with satisfactory adhesion and burial characteristics without involving impurities remaining in the film.

According to the present invention, there is also provided a metal film production method comprising: supplying a source gas containing a halogen to an interior of a chamber between a substrate and a metallic etched member such that the source gas is gradually increased from a flow rate of 0 to a predetermined flow rate to increase a particle size of a metal component gradually, and such that the source gas is intermittently supplied to suppress a relative increase in etching particles; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to increase the particle size gradually and form the metal component of the precursor into a film on the substrate, while increasing the particle size gradually. Thus, immediately after start of film formation, the metal component with a small particle size is formed into a film. Then, the particle size of the metal component is gradually increased to a predetermined size. Moreover, a relative increase in etching particles is suppressed. As a result, a metal film can be prepared with high adhesion and with the film formation speed being increased. Consequently, it is possible to construct a metal film production method which has a high film formation speed, which can use an inexpensive starting material, and which can produce a metal film with satisfactory adhesion without involving impurities remaining in the film.

According to the present invention, there is also provided a metal film production method comprising: supplying a source gas containing a halogen to an interior of a chamber between a substrate and a metallic etched member such that the source gas is increased to a predetermined flow rate in multiple stages to increase a particle size of a metal component stepwise, also such that the source gas is gradually increased at start of each increase to increase the particle size of the metal component gradually, and further such that the source gas is intermittently supplied to suppress a relative increase in etching particles; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while increasing the particle size stepwise, also increasing the particle size gradually, and also suppressing the relative increase in the etching particles. Thus, even if the substrate has a trench or the like, the metal component is formed into a film within the trench immediately after film formation. Then, the particle size of the metal component is increased to a predetermined value. Moreover, immediately after start of film formation, the metal component with a small particle size is formed into a film. Then, the particle size of the metal component is gradually increased to a predetermined size. Moreover, a relative increase in etching particles is suppressed. As a result, a metal film can be prepared with high burial characteristics and high adhesion as well as an improvement in the film formation speed. Consequently, it is possible to construct a metal film production method which has a high film formation speed, which can use an inexpensive starting material, and which can produce a metal film with satisfactory adhesion and burial characteristics without involving impurities remaining in the film.

In the metal film production method, the source gas containing the halogen may be the source gas containing chlorine. The etched member may be made of copper so that $Cu_xCl_y$ is formed as the precursor. Alternatively, the etched member may be made of tantalum, tungsten or titanium which is a halide-forming metal.

BRIEF DESCRIPTION OF THE DRAWINGS

The present invention will become more fully understood from the detailed description given hereinbelow and the accompanying drawings which are given by way of illustration only, and thus are not limitative of the present invention, and wherein:

FIG. 1 is a schematic side view of a metal film production apparatus according to a first embodiment of the present invention;

FIG. 2 is a graph showing the time course of the CuCl concentration;

FIG. 3 is a graph showing the time course of source gas supply;

FIG. 4 is a graph showing the time course of the film thickness;

FIG. 5 is a block diagram of control means applied to a metal film production apparatus according to a second embodiment of the present invention;

FIG. 6 is a schematic construction drawing of a metal film production apparatus according to a third embodiment of the present invention;

FIG. 7 is a schematic construction drawing of a metal film production apparatus according to a fourth embodiment of the present invention;

FIG. 8 is a schematic construction drawing of a metal film production apparatus according to a fifth embodiment of the present invention; and

FIG. 9 is a graph showing another example of the time course of source gas supply.

FIG. 10 is a schematic side view of a metal film production apparatus according to a sixth embodiment of the present invention;

FIG. 11 is a graph showing the time courses of the flow rates of a source gas a the rare gas;

FIGS. 12(a) to 12(c) are sectional views of the surface of a substrate;

FIG. 13 is a schematic construction drawing of a metal film production apparatus according to a seventh embodiment of the present invention;

FIG. 14 is a schematic construction drawing of a metal film production apparatus according to an eighth embodiment of the present invention;

FIG. 15 is a schematic construction drawing of a metal film production apparatus according to a ninth embodiment of the present invention;

FIG. 16 is a graph showing the time course of the flow rate of the source gas in a metal film production apparatus according to a tenth embodiment of the present invention;

FIG. 17 is a sectional view of the surface of the substrate;

FIG. 18 is a graph showing the time course of the flow rate of the source gas for illustrating an eleventh embodiment of the present invention;

FIG. 19 is a graph showing the time course of the flow rate of the source gas supplied in an intermittent manner;

FIG. 20 is a graph showing the time course of the flow rate of the source gas supplied in an intermittent manner; and

FIG. 21 is a graph showing the time course of the flow rate of the source gas supplied in an intermittent manner.

## DESCRIPTION OF THE PREFERRED EMBODIMENTS

Preferred embodiments of a metal film production apparatus and a metal film production method according to the present invention will now be described in detail with reference to the accompanying drawings, which in no way limit the invention.

In a first aspect of the present invention, the metal film production apparatus and the metal film production method are designed to supply a source gas containing chlorine, as a halogen, to the interior of a chamber between a substrate and an etched member made of a metal (Cu) such that the source gas is intermittently supplied to suppress a relative increase in etching particles; convert an atmosphere within the chamber into a plasma to generate a chlorine gas plasma so that the copper plate member is etched with the chlorine gas plasma to form a precursor from the Cu component contained in the copper plate member and the chlorine gas; and make the temperature of the substrate lower than the temperature of the copper plate member to form the Cu component of the precursor into a film on the substrate, while suppressing the relative increase in the etching particles.

Means for bringing the source gas into an intermittently supplied state may be to control the supply of the source gas, or to control the state of exhaust. In supplying the source gas intermittently, the source gas may be intermittently supplied in a preset pulsed state or sine wave state. Alternatively, the source gas may be intermittently supplied by detecting plasma particles which contribute to film formation, or plasma particles which impede film formation, and stopping the supply of the source gas when the plasma particles contributing to film formation are decreased, or when the plasma particles impeding film formation are increased.

Preferably, the relation between a period of time T for which the source gas is supplied, and a period of time t for which the source gas is not supplied, is set as follows:

$$0.03 \leq t/T \leq 0.10$$

Because of the above feature, the source gas can be supplied in the full presence of plasma particles contributing to film formation. Moreover, the source gas can be supplied in a state in which a Cu film formed is not etched with etching particles. Consequently, the Cu film can be reliably increased with respect to the film formation time to increase the film formation speed. Hence, the Cu wiring process is stabilized.

In supplying the source gas intermittently, a rare gas (for example, an He gas) is supplied in an adjusted amount according to the supply of the source gas, and the plasma is generated. By so doing, the source gas can be intermittently supplied in a stable plasma condition, with the amount of gases being maintained. The supply of the rare gas can be omitted.

In supplying the rare gas in an adjusted manner according to the supply of the source gas, the diluent gas for the source gas can be used as the rare gas, and the rare gas and the source gas can be supplied simultaneously through a single nozzle via a mixing tank. In this case, the number of pipings may be small, so that the cost can be reduced. Alternatively, the supply lines for the source gas and the rare gas can be provided independently, so that the rare gas and the source gas can be supplied separately through the two lines. In this case, the amounts of the source gas and the rare gas supplied can be controlled easily.

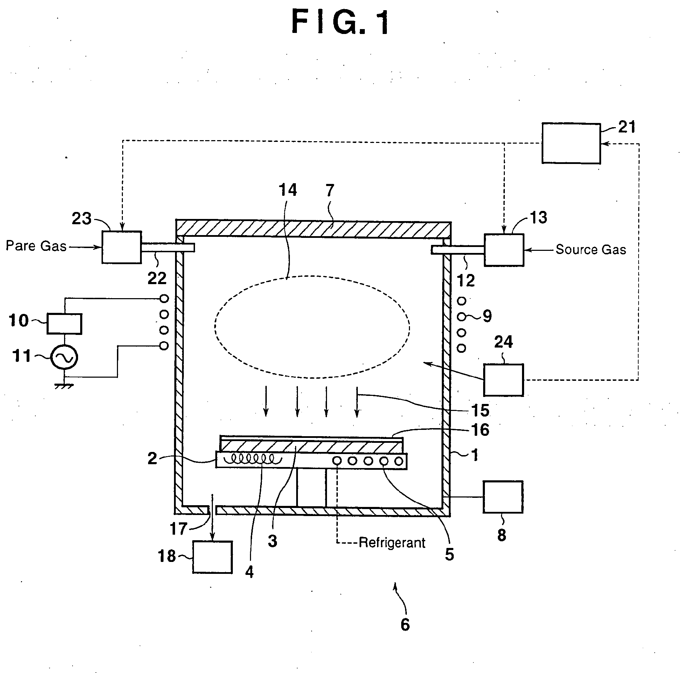

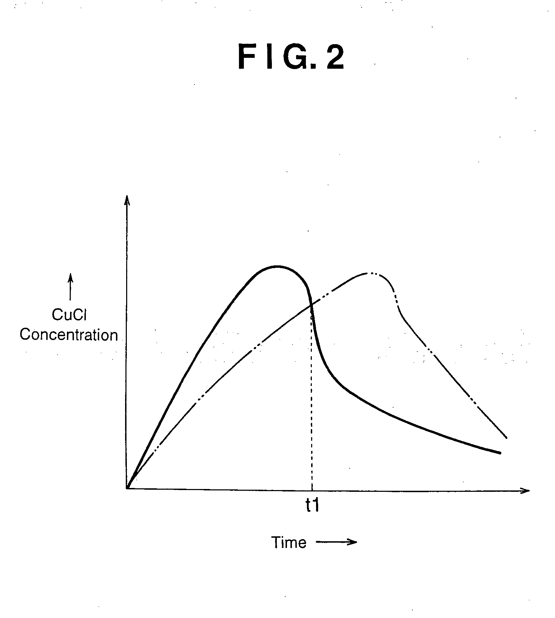

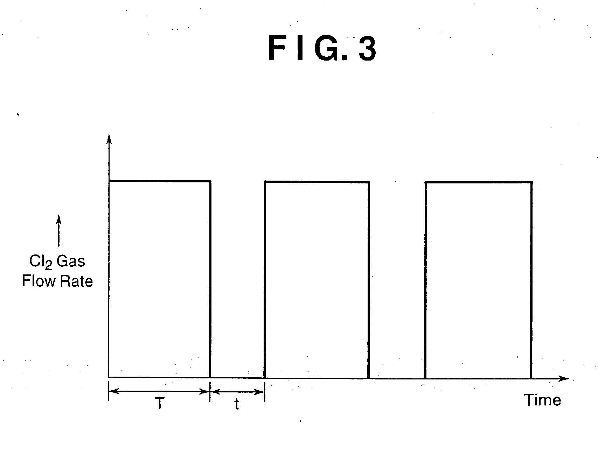

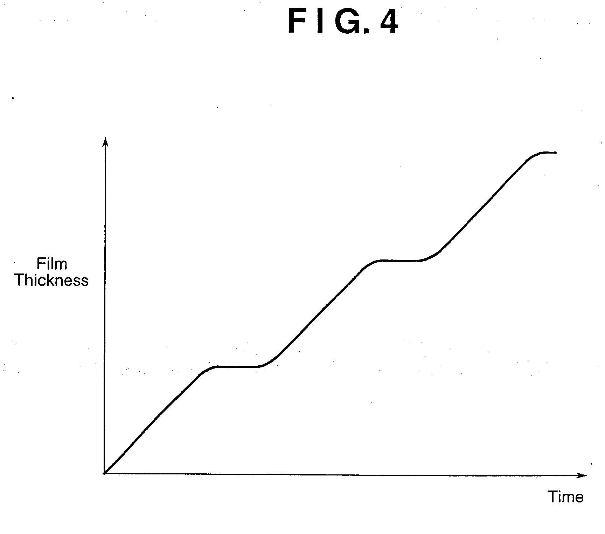

A first embodiment of a metal film production apparatus and a metal film production method according to the present invention will be described with reference to FIGS. 1 to 4. FIG. 1 is a schematic side view of the metal film production apparatus according to the first embodiment of the present invention. FIG. 2 shows the time course of the CuCl concentration. FIG. 3 shows the time course of source gas supply. FIG. 4 shows the time course of the film thickness.

As shown in FIG. 1, a support platform 2 is provided near the bottom of a cylindrical chamber 1 made of, say, a ceramic (an insulating material), and a substrate 3 is placed on the support platform 2. Temperature control means 6 equipped with a heater 4 and refrigerant flow-through means 5 is provided in the support platform 2 so that the support platform 2 is controlled to a predetermined temperature (for example, a temperature at which the substrate 3 is maintained at 100 to 200°C) by the temperature control means 6. An upper surface of the chamber 1 is an opening, which is closed with a copper plate member 7, as an etched member made of a metal. The interior of the chamber 1 closed with the copper plate member 7 is maintained at a predetermined pressure by a vacuum device 8.

A coiled plasma antenna 9 is provided around a cylindrical portion of the chamber 1. A matching instrument 10 and a power source 11 are connected to the plasma antenna 9 to supply power. Plasma generation means is constituted by the plasma antenna 9 , matching instrument 10 and power source 11.

Nozzles 12 for supplying a source gas (a $Cl_2$ gas diluted with He or Ar to a chlorine concentration of $\leq 50\%$, preferably about 10%), containing chlorine as a halogen, to the interior of the chamber 1 are connected to the cylindrical portion of the chamber 1 above the support platform 2. The nozzle 12 is open toward the copper plate member 7, and the nozzle 12 is fed with the source gas via a flow controller 13 (source gas supply means). Fluorine (F), bromine (Br) or iodine (I) can also be applied as the halogen to be incorporated into the source gas.

With the above-described metal film production apparatus, the source gas is supplied from the nozzles 12 into the chamber 1, and electromagnetic waves are shot from the plasma antenna 9 into the chamber 1, whereby the $Cl_2$ gas is ionized to generate a $Cl_2$ gas plasma (source gas plasma) 14. The $Cl_2$ gas plasma 14 causes an etching reaction to the copper plate member 7, forming a precursor ($Cu_xCl_y$) 15. At this time, the copper plate member 7 is maintained by the $Cl_2$ gas plasma 14 at a predetermined temperature (e.g., 200 to 400°C) which is higher than the temperature of the substrate 3.

The precursor ($Cu_xCl_y$) 15 formed within the chamber 1 is transported toward the substrate 3 controlled to a lower temperature than the temperature of the copper plate member 7. The precursor ($Cu_xCl_y$) 15 transported toward the substrate 3 is directed at the substrate 3, and converted into only Cu ions by a reduction reaction (an etching action by Cl radicals), to form a thin Cu film 16 on the surface of the substrate 3.

The reactions involved on this occasion can be expressed by:

$$2Cu + Cl_2 \rightarrow 2CuCl \rightarrow 2Cu\downarrow + Cl_2\uparrow$$

The gases and the etching products that have not been involved in the reactions are exhausted from an exhaust port 17 through exhaust means 18.

The source gas has been described, with the $Cl_2$ gas diluted with, say, He or Ar taken as an example. However, the $Cl_2$ gas can be used alone, or an HCl gas can also be applied. If the HCl gas is applied, an HCl gas plasma is generated as the source gas plasma. However, the precursor formed by etching of the copper plate member 7 is $Cu_xCl_y$. Thus, the source gas may be any gas containing chlorine, and a gas mixture of an HCl gas and a $Cl_2$ gas is also usable. The material for the copper plate member 7 is not limited to copper (Cu), but it is possible to use a halide forming metal, preferably a chloride forming metal, such as Ag, Au, Pt, Ta, Ti or W. In this case, the resulting precursor is a halide (chloride) of Ag, Au, Pt, Ta, Ti or W, and the thin film formed on the surface of the substrate 3 is that of Ag, Au, Pt, Ta, Ti or W.

Since the metal film production apparatus constructed as above uses the $Cl_2$ gas plasma (source gas plasma) 14, the reaction efficiency is markedly increased, and the speed of film formation is fast. Since the $Cl_2$ gas is used as the source gas, moreover, the cost can be markedly decreased. Furthermore, the substrate 3 is controlled to a lower temperature than the temperature of the copper plate member 7 by use of the temperature control means 6. Thus, the amounts of impurities, such as chlorine, remaining in the thin Cu film 16 can be decreased, so that a high quality thin Cu film 16 can be produced.

The metal film production apparatus of the present embodiment is equipped with control means 21 for suppressing a relative increase in etching particles by supplying the source gas intermittently. That is, the flow rate of the $Cl_2$ gas through the flow controller 13 is controlled by a command from the control means 21. Also, rare gas nozzles 22 are provided for supplying a rare gas (for example, He gas) at a predetermined flow rate in response to the intermittent supply of the source gas to generate an He gas plasma. An He gas is fed to the rare gas nozzle 22 through a flow controller 23 (rare gas supply means). A command from the control means 21 is inputted into the flow controller 23 to control the flow rate of the He gas through the flow controller 23. By supplying the He gas, the source gas can be supplied intermittently in a stable plasma state, with the gas amount being maintained.

The metal film production apparatus of the present embodiment is also provided with a plasma spectroscope 24, as detection means, for detecting a CuCl plasma (light emission intensity), which is plasma particles contributing to film formation within the chamber 1. Detection information from the plasma spectroscope 24 is inputted into the control means 21. The control means 21 issues a control command to the flow controller 13 and the flow controller 23 so as to stop the supply of the $Cl_2$ gas when the CuCl plasma decreases (details to be offered later), and to supply the He gas in accordance with the stoppage of supply of the $Cl_2$ gas. Under this control, intermittent supply of the $Cl_2$ gas is effected.

As means for achieving the intermittent supply of the $Cl_2$ gas, it is also possible to keep the supply of the $Cl_2$ gas through the nozzle 12 constant and control the exhaust situation by the exhaust means 18, thereby producing an intermittent supply of the $Cl_2$ gas. In this case, the gas amount is kept constant. Thus, the rare gas nozzles 22 and the flow controller 23 for supply of He gas can be omitted.

The mechanism of film formation in each of the above-described embodiments is to etch copper by converting the $Cl_2$ gas into a plasma. In the presence of a large amount of CuCl in the precursor 15, Cu contributing to film formation also stably deposits on the substrate 3. When the $Cl_2$ gas is converted into a plasma, chlorine radicals ($Cl_*$) react with Cl within the chamber 1 to form $Cl_2$, or chlorine radicals ($Cl_*$) react with CuCl to form $CuCl_2$. Moreover, chlorine radicals ($Cl_*$) collide with each other and decrease. Because of these secondary reactions, as film formation proceeds, CuCl decreases, and film formation does not progress any more. Also, the phenomenon may arise that the thin Cu film 16, once formed, is etched with the resulting $Cl_2$ or $CuCl_2$.

Thus, when the increase in CuCl peaks, the supply of the $Cl_2$ gas is stopped, and the chamber 1 is once evacuated to exhaust chlorine radicals ($Cl_*$). Then, $Cl_2$ gas is supplied anew, and converted into a plasma, namely, $Cl_2$ gas is supplied intermittently. By this means, the decrease in the amount of CuCl due to the secondary reactions and the etching reaction can be suppressed to curtail the decline in the efficiency of film formation. As a result, the thickness of film formed can be increased relative to the total time taken for film formation, and the film formation speed can be increased.

That is, as shown in FIG. 2, CuCl increases over time, and Cu contributing to film formation also stably deposits on the substrate 3. With the passage of time, chlorine radicals ($Cl_*$) react with Cl to form $Cl_2$, or chlorine radicals ($Cl_*$) react with CuCl to form $CuCl_2$. As a result, CuCl decreases. The amount of CuCl is in proportional relationship with the film thickness. Thus, if CuCl decreases, the film thickness does not increase (but decreases) even when time passes.

Therefore, the CuCl plasma is detected by the plasma spectroscope 24, and when the CuCl plasma peaks and begins to decrease, the supply of the $Cl_2$ gas is stopped. In stopping the supply of the $Cl_2$ gas, the threshold value of the CuCl concentration is preset. When it is detected that the CuCl concentration has fallen short of the threshold value from a value higher than it (i.e. at t1), the supply of the $Cl_2$ gas is stopped. Supply of $Cl_2$ gas may be resumed, for example, either when a predetermined period of time elapses after stopping the supply, or depending on the situation of detection of the CuCl plasma, such as after the CuCl plasma has decreased. Furthermore, after supply of the $Cl_2$ gas is stopped, the light emission intensity of the Cl plasma is detected, and when the Cl plasma is exhausted to reach a predetermined decreased amount, supply of $Cl_2$ gas can be resumed.

It is also possible to detect the light emission intensity of the Cl plasma (indicated by two-dot chain lines in FIG. 2), the cause of the decrease in CuCl, and stop the supply of the $Cl_2$ gas depending on the situation of the Cl plasma. In this case, there may be a state in which a time delay occurs in the situation of an increase in CuCl plasma. Thus, in consideration of the time delay, it is set when the supply of the $Cl_2$ gas should be stopped. By setting the stoppage of supply of the $Cl_2$ gas depending on the situation of the Cl plasma, the resumption of supply of $Cl_2$ gas can be controlled based on the same situation of detection.

As described above, when the CuCl plasma peaks and begins to decrease, the supply of the $Cl_2$ gas is stopped, and then the supply of $Cl_2$ gas is resumed. By so doing, supply of $Cl_2$ gas is performed intermittently, as shown in FIG. 3. By retaining the points of time when the CuCl plasma peaks, the film thickness always increases while $Cl_2$ gas is being supplied, as shown in FIG. 4. This avoids the situation, as shown in FIG. 2, where CuCl contributing to film formation decreases and the film thickness does not increase (but decreases) even with the passage of time. Thus, by grasping the situation of the CuCl plasma, the film thickness can be increased highly efficiently relative to the total duration of supply of $Cl_2$ gas, and the film formation speed can be increased.

Hence, $Cl_2$ gas can be supplied in the full presence of the CuCl plasma, which is plasma particles contributing to film formation. Moreover, $Cl_2$ gas can be sup-

plied in a state in which the thin Cu film 16 formed (see FIG. 1) is not etched with the Cl plasma which is etching particles. The situation of the CuCl plasma is accurately grasped, whereby the thin Cu film 16 (FIG. 1) can be reliably increased with respect to the film formation time to increase the film formation speed.

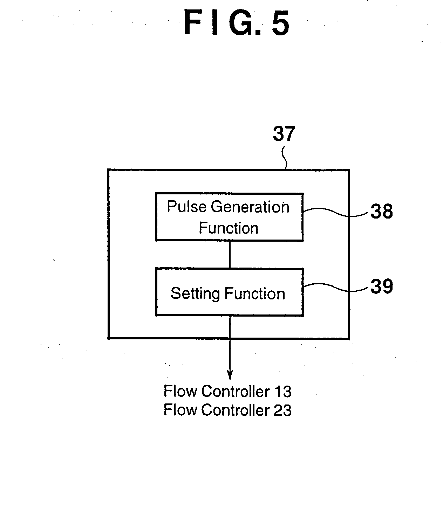

A second embodiment of the present invention will be described with reference to FIG. 5. FIG. 5 shows a block configuration of control means which is applied to a metal film production apparatus according to the second embodiment of the present invention. The present embodiment has a construction in which control means 37 shown in FIG. 5 is provided instead of the control means 21 of the metal film production apparatus shown in FIG. 1 and the plasma spectroscope 24 is omitted. Thus, the construction of the metal film production apparatus, other than the actions of the control means 21, remains unchanged, and so its illustration and explanation are omitted.

As shown in FIG. 5, the metal film production apparatus of the present embodiment is equipped with the control means 37 for suppressing a relative increase in etching particles by supplying the source gas in a pulsed manner to achieve an intermittent supply of the source gas. That is, the flow rate of the $Cl_2$ gas through the flow controller 13 is controlled by a command from the control means 37. Also, an He gas is fed through the flow controller 23 to the rare gas nozzle 22 (see FIG. 1) which supplies a rare gas (for example, He gas) at a predetermined flow rate (rare gas supply means) in response to the pulsed supply of the source gas to generate an He gas plasma. A command from the control means 37 is inputted into the flow controller 23 to control the flow rate of the He gas through the flow controller 23. By supplying the He gas, the source gas can be supplied intermittently in a stable plasma state, with the gas amount being maintained.

The control means 37 is provided with a pulse generation function 38, and a setting function 39 for setting the ratio between the time of supply of $Cl_2$ gas and the time of stoppage of $Cl_2$ gas. The flow controller 13 and the flow controller 23 are controlled in accordance with the ratio set by the setting function 39. The setting function 39 presets t/T, the ratio between the time for which the $Cl_2$ gas is supplied (T; see FIG. 3) and the time for which the $Cl_2$ gas is not supplied (t; see FIG. 3), as follows:

$$0.03 \leq t/T \leq 0.10$$

For example, the time T is set to be between 30 seconds and 180 seconds, and the time t between 1 second and 10 seconds. By so doing, supply of $Cl_2$ gas can be performed unerringly and intermittently without using detection means.

As described above, the control means 37 exercises control such that $Cl_2$ gas is supplied in a pulsed manner. By so doing, supply of $Cl_2$ gas is performed intermittently, as shown in FIG. 3. In the same manner as mentioned earlier, the film thickness always increases while $Cl_2$ gas is being supplied. This avoids the situation where CuCl contributing to film formation decreases and the film thickness does not increase (but decreases) even with the passage of time. Thus, simple control makes it possible to increase the film thickness highly efficiently relative to the total time of supply of $Cl_2$ gas, and increase the film formation speed.

Hence, $Cl_2$ gas can be supplied in the full presence of the CuCl plasma, which is plasma particles contributing to film formation. Moreover, $Cl_2$ gas can be supplied in a state in which the thin Cu film 16 formed (see FIG. 1) is not etched with the Cl plasma which is etching particles. Consequently, the thin Cu film 16 (FIG. 1) can be reliably increased, using simple control, with respect to the film formation time to increase the film formation speed.

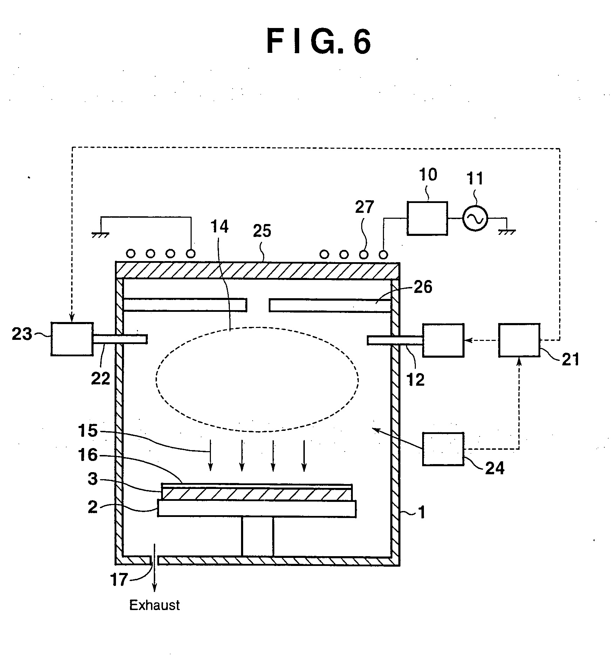

Third to fifth embodiments of the metal film production apparatus will be described with reference to FIGS. 6 to 8. In the metal film production apparatuses illustrated below, similar to the aforementioned apparatuses, a source gas containing chlorine as a halogen is intermittently supplied to the interior of a chamber 1 between a substrate and an etched member made of a metal (Cu) by control means 21 (or control means 37). Because of this feature, the film thickness can be increased highly efficiently relative to the total time of supply of $Cl_2$ gas, and the film formation speed can be increased.

FIGS. 6 to 8 show a schematic construction of the metal film production apparatus according to each of the third to fifth embodiments of the present invention. The same members as in the metal film production apparatus shown in FIG. 1 are assigned the same numerals, and duplicate explanations are omitted.

In the metal film production apparatus as the third embodiment shown in FIG. 6, an upper surface of the chamber 1 is an opening, which is closed with a disk-shaped ceiling board 25 made of an insulating material (for example, a ceramic). An etched member 26 made of a metal (Cu) is interposed between the opening at the upper surface of the chamber 1 and the ceiling board 25. A plasma antenna 27, for converting the atmosphere inside the chamber 1 into a plasma, is provided above the ceiling board 25. The plasma antenna 27 is formed in a planar ring shape parallel to the surface of the ceiling board 25. A matching instrument 10 and a power source 11 are connected to the plasma antenna 27 to supply power. The etched member 26 has a plurality of protrusions provided in the circumferential direction on the inner periphery of a ring portion, and includes notches (spaces) formed between the protrusions. Thus, the protrusions are arranged between the substrate 3 and the ceiling board 25 in a discontinuous state relative to the flowing direction of electricity in the plasma antenna 27.

With the above-described metal film production apparatus, the source gas is supplied through nozzles 12 to the interior of the chamber 1, and electromagnetic waves are shot from the plasma antenna 27 into the chamber 1. As a result, $Cl_2$ gas is ionized to generate a $Cl_2$ gas plasma (source gas plasma) 14. The etched member 26, an electric conductor, is present below the plasma antenna 27. However, the $Cl_2$ gas plasma 14 occurs stably between the etched member 26 and the substrate 3, namely, below the etched member 26, because the etched member 26 is disposed in a discontinuous state relative to the flowing direction of electricity in the plasma antenna 27. The situation of plasma particles within the chamber 1 is detected by the plasma spectroscope 24, and the $Cl_2$ gas is supplied in an intermittent manner by the control means 21.

With the metal film production apparatus shown in FIG. 6, even though the etched member 26, an electric conductor, exists below the plasma antenna 27, the electromagnetic waves are reliably thrown from the plasma antenna 27 into the chamber 1. Consequently, the $Cl_2$ gas plasma 14 can be stably generated below the etched member 26.

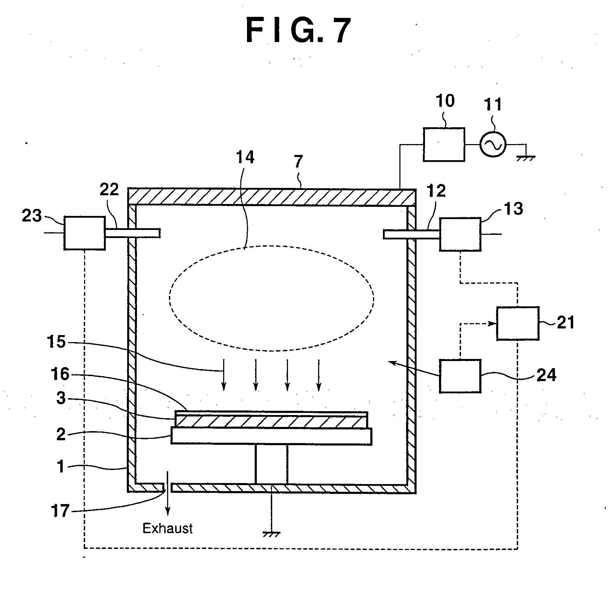

Compared with the metal film production apparatus shown in FIG. 1, the metal film production apparatus of the fourth embodiment shown in FIG. 7 is constructed such that the plasma antenna 9 is not provided around the cylindrical portion of the chamber 1, but the matching instrument 10 and power source 11 are connected to the copper plate member 7 for supply of power to the copper plate member 7.

The source gas is supplied from the nozzles 12 into the chamber 1, and electromagnetic waves are shot from the copper plate member 7 into the chamber 1, whereby the $Cl_2$ gas is ionized to generate a $Cl_2$ gas plasma (source gas plasma) 14. The $Cl_2$ gas plasma 14 causes an etching reaction to the copper plate member 7, forming a precursor 15. At this time, the copper plate member 7 is maintained at a temperature (e.g., 200 to 400°C), which is higher than the temperature of the substrate 3, by temperature control means (not shown). The situation of plasma particles within the chamber 1 is detected by the plasma spectroscope 24, and the $Cl_2$ gas is supplied in an intermittent manner by the control means 21.

With the metal film production apparatus shown in FIG. 7, the copper plate member 7 itself is applied as an electrode for plasma generation. Thus, the plasma antenna 9 need not be provided around the cylindrical portion of the chamber 1, and the degree of freedom of the surrounding construction can be increased.

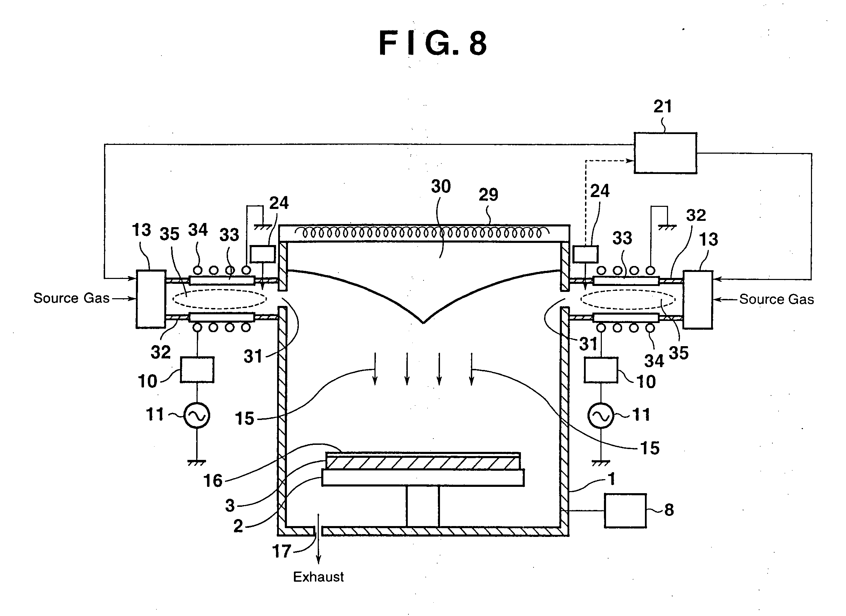

In the metal film production apparatus of the fifth embodiment shown in FIG. 8, the upper surface of the chamber 1 is an opening, and the opening is closed with a ceiling board 29, for example, made of a ceramic (an insulating material). An etched member 30 made of a metal (copper, Cu) is provided on a lower surface of the ceiling board 29, and the etched member 30 is of a quadrangular pyramidal shape. Slit-shaped opening portions 31 are formed in the periphery of the cylindrical portion of the chamber 1, and one end of a tubular passage 32 is fixed to each of the opening portions 31.

A tubular excitation chamber 33 made of an insulator is provided halfway through the passage 32, and a coiled plasma antenna 34 is provided around the excitation chamber 33. The plasma antenna 34 is connected to a matching instrument 10 and a power source 11 to receive power. A flow controller 13 is connected to the other end of the passage 32, and a source gas is supplied into the passage 32 via the flow controller 13.

By shooting electromagnetic waves from the plasma antenna 34 into the excitation chamber 33, the $Cl_2$ gas is ionized to generate a $Cl_2$ gas plasma (source gas plasma) 35. This means that the source gas is excited in the excitation chamber 33 isolated from the chamber 1. Because of the generation of the $Cl_2$ gas plasma 35, excited chlorine is fed into the chamber 1 through the opening portion 31, whereupon the etched member 30 is etched with excited chlorine. The situation of plasma particles within the excitation chamber 33 is detected by a plasma spectroscope 24, and the $Cl_2$ gas is supplied in an intermittent manner by the control means 21.

The source gas is supplied into the passage 32 via the flow controller 13 and fed into the excitation chamber 33. By shooting electromagnetic waves from the plasma antenna 34 into the excitation chamber 33, the $Cl_2$ gas is ionized to generate a $Cl_2$ gas plasma (source gas plasma) 35. Since a predetermined differential pressure has been established between the pressure inside the chamber 1 and the pressure inside the excitation chamber 33 by the vacuum device 8, the excited chlorine of the $Cl_2$ gas plasma 35 in the excitation chamber 33 is fed to the etched member 30 inside the chamber 1 through the opening portion 31. The excited chlorine causes an etching reaction to the etched member 30, forming a precursor ($Cu_xCl_y$) 15 inside the chamber 1.

With the metal film production apparatus shown in FIG. 8, the $Cl_2$ gas plasma 35 is generated in the excitation chamber 33 isolated from the chamber 1. Thus, the substrate 3 is not exposed to the plasma any more, and the substrate 3 becomes free from damage from the plasma. In the substrate 3 having a film of a different material formed during a preceding step, for example, the film of the material formed during the preceding step is free from damage. As the means for generating the $Cl_2$ gas plasma 35 in the excitation chamber 33 (excitation means), it is possible to use microwaves, laser, electron rays, or synchrotron radiation. The metal film production apparatus shown in FIG. 8 does not generate plasma within the chamber 1. Thus, there is no need to supply a rare gas in order to stabilize the plasma within the chamber 1.

In the metal film production apparatus illustrated in each of FIGS. 6 to 8, similar to the aforementioned apparatuses, the source gas containing chlorine as a halogen is intermittently supplied to the interior of the chamber 1. Because of this feature, the film thickness can be increased highly efficiently relative to the total time of supply of $Cl_2$ gas, and the film formation speed can be increased.

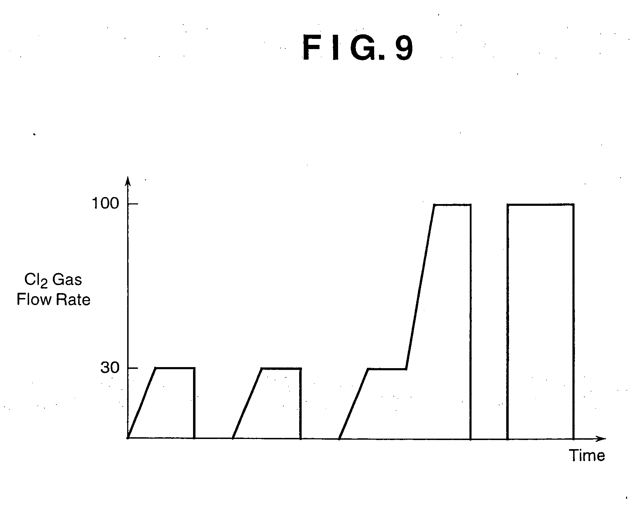

In intermittently supplying $Cl_2$ gas, $Cl_2$ gas can be gradually increased at the start of film formation, and $Cl_2$ gas can also be increased in two stages, as shown in FIG. 9. By gradually increasing $Cl_2$ gas at the start of film formation, Cu particles at the start of film formation can be made small, and then grown to a predetermined size, whereby adhesion can be improved. By increasing $Cl_2$ gas in two stages, the inside of trenches, if provided in the substrate 3 for wiring formation, can be reliably stacked with Cu particles in layers, whereby burial characteristics can be improved.

Additionally, the metal film production apparatus and the metal film production method of the present invention are designed to produce a film of a metal component, for example, a film of copper (Cu), with high adhesion on a layer for prevention of diffusion, for example, a barrier metal layer of tantalum nitride (TaN), which has been prepared on the surface of a substrate.

In a second aspect, the present invention supplies a source gas containing chlorine, as a halogen, to the interior of a chamber between a substrate and an etched member made of a metal (Cu) such that the source gas is gradually increased continuously from a flow rate of 0 to a predetermined flow rate to increase the particle size of the metal component (Cu component) gradually; converts an atmosphere within the chamber into a plasma to generate a chlorine gas plasma so that the copper plate member is etched with the chlorine gas plasma to form a precursor from the Cu component contained in the copper plate member and the chlorine gas; and makes the temperature of the substrate lower than the temperature of the copper plate member to form the Cu component of the precursor into a film on the substrate, while gradually increasing particles of the precursor.

The source gas is gradually increased continuously, but may be gradually increased stepwise. In this case as well, the Cu component of the precursor is formed into a film on the substrate, with particles of the precursor being gradually increased.

According to the above feature, immediately after start of film formation, the generation of particles of the precursor, including etching particles, which inhibit adhesion, is suppressed, and the Cu component with a small particle size is formed into a film. Then, the particle size of the Cu Component gradually increases to a predetermined size. As a result, a Cu film with high adhesion can be prepared on the surface of the substrate. Furthermore, the source gas is gradually increased continuously, so that the Cu component can be reliably changed from a small particle size to a large particle size. In increasing the source gas gradually continuously, a rare gas (for example, an He gas) is supplied in such a manner as to be decreased gradually according to the gradual increase in the source gas. In this state, the plasma is generated. By so doing, the source gas can be gradually increased continuously in a stable plasma condition, with the total amount of gases being maintained at a constant level. The supply of the rare gas can be omitted.

In supplying the rare gas so as to be decreased gradually according to the gradual increase in the source gas, the diluent gas for the source gas can be used as the rare gas, and the rare gas and the source gas can be supplied simultaneously through a single nozzle via a mixing tank. In this case, the number of pipings may be small, so that the cost can be reduced. Alternatively, the supply lines for the source gas and the rare gas can be provided independently, so that the rare gas and the source gas can be supplied separately through the two lines. In this case, the amounts of the source gas and the rare gas supplied can be controlled easily.

The function of the gradual increase in the source gas is appropriately set according to the material for the barrier metal layer or the metal to be formed into a film. If the metal to be formed into a film is Cu and the barrier metal layer is tantalum nitride (TaN), for example, it is preferred to increase the source gas linearly. If the metal to be formed into a film is Cu and the barrier metal layer is tungsten nitride (WN), it is preferred to increase the source gas relatively quickly, since tungsten has high adhesion to Cu compared with tantalum. If the metal to be formed into a film is Cu and the barrier metal layer is titanium nitride (TiN), it is preferred to increase the source gas relatively slowly, since titanium has low adhesion to Cu compared with tantalum. By these means, the particle size of the Cu component can be optimized to suit the material.

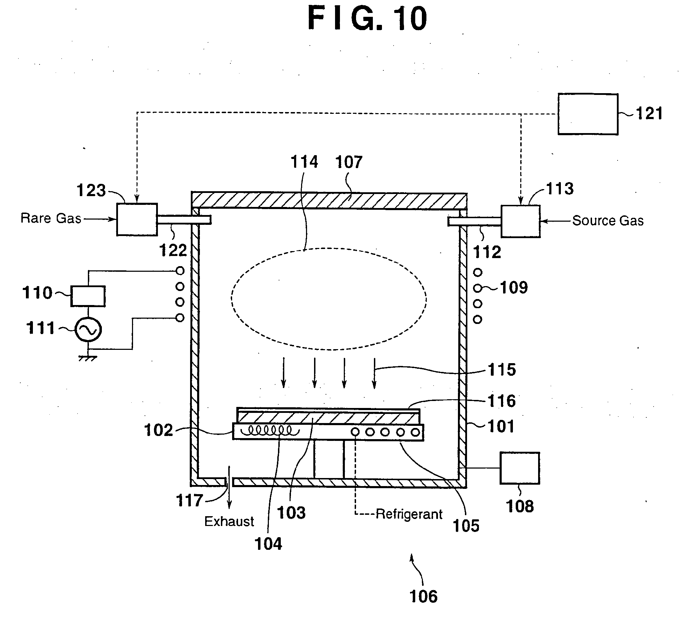

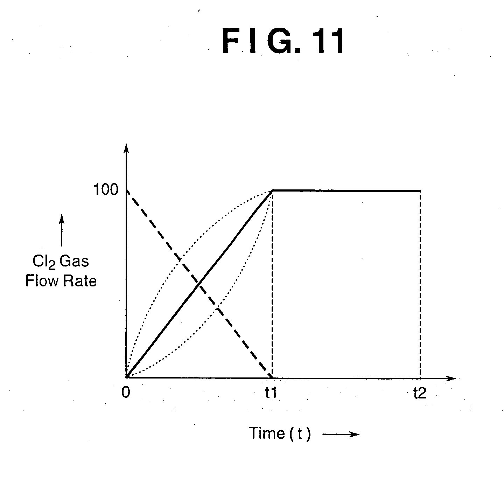

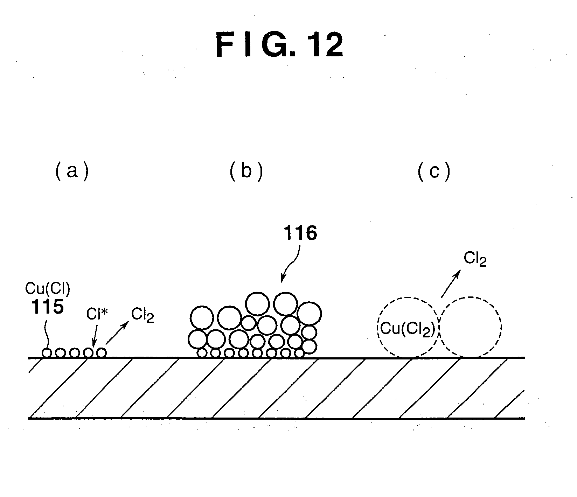

A sixth embodiment of a metal film production apparatus and a metal film production method according to the present invention will be described with reference to FIGS. 10 to 12. FIG. 10 is a schematic side view of the metal film production apparatus according to the sixth embodiment of the present invention. FIG. 11 shows the time courses of the flow rates of the source gas and the rare gas. FIGS. 12(a) to 12(c) show the sectional situation of the surface of the substrate.

As shown in FIG. 10, a support platform 102 is provided near the bottom of a cylindrical chamber 101 made of, say, a ceramic (an insulating material), and a substrate 103 is placed on the support platform 102. Temperature control means 106 equipped with a heater 104 and refrigerant flow-through means 105 is provided in the support platform 102 so that the support platform 102 is controlled to a predetermined temperature (for example, a temperature at which the substrate 103 is maintained at 100 to 200°C) by the temperature control means 106. An upper surface of the chamber 101 is an opening, which is closed with a copper plate member 107, as an etched member made of a metal. The interior of the chamber 101 closed with the copper plate member 107 is maintained at a predetermined pressure by a vacuum device 108.

A coiled plasma antenna 109 is provided around a cylindrical portion of the chamber 101. A matching instrument 110 and a power source 111 are connected to the plasma antenna 109 to supply power. Plasma generation means is constituted by the plasma antenna 109, matching instrument 110 and power source 111.

Nozzles 112 for supplying a source gas (a $Cl_2$ gas diluted with He or Ar to a chlorine concentration of $\leq$ 50%, preferably about 10%), containing chlorine as a halogen, to the interior of the chamber 101 are connected to the cylindrical portion of the chamber 101 above the support platform 102. The nozzle 112 is open toward the copper plate member 107, and the nozzle 112 is fed with the source gas via a flow controller 113 (source gas supply means). Fluorine (F), bromine (Br) or iodine (I) can also be applied as the halogen to be incorporated into the source gas.

With the above-described metal film production apparatus, the source gas is supplied from the nozzles 112 into the chamber 101, and electromagnetic waves are shot from the plasma antenna 109 into the chamber 101, whereby the $Cl_2$ gas is ionized to generate a $Cl_2$ gas plasma (source gas plasma) 114. The $Cl_2$ gas plasma 114 causes an etching reaction to the copper plate member 107, forming a precursor $(Cu_xCl_y)$ 115. At this time, the copper plate member 107 is maintained by the $Cl_2$ gas plasma 114 at a predetermined temperature (e.g., 200 to 400°C) which is higher than the temperature of the substrate 103.

The precursor $(Cu_xCl_y)$ 115 formed within the chamber 101 is transported toward the substrate 103 controlled to a lower temperature than the temperature of the copper plate member 107. The precursor $(Cu_xCl_y)$ 115 transported toward the substrate 103 is directed at the substrate 103, and converted into only Cu ions by a reduction reaction (an etching action by Cl radicals), to form a thin Cu film 116 on the surface of the substrate 103.

The reactions involved on this occasion can be expressed by:

$$2Cu + Cl_2 \rightarrow 2CuCl \rightarrow 2Cu\downarrow + Cl_2\uparrow$$

The gases and the etching products that have not been involved in the reactions are exhausted from an exhaust port 117.

The source gas has been described, with the $Cl_2$ gas diluted with, say, He or Ar taken as an example. However, the $Cl_2$ gas can be used alone, or an HCl gas can also be applied. If the HCl gas is applied, an HCl gas plasma is generated as the source gas plasma. However, the precursor formed by etching of the copper plate member 107 is $Cu_xCl_y$. Thus, the source gas may be any gas containing chlorine, and a gas mixture of an HCl gas and a $Cl_2$ gas is also usable. The material for the copper plate member 107 is not limited to copper (Cu), but it is possible to use a halide forming metal, preferably a chloride forming metal, such as Ag, Au, Pt, Ta, Ti or W. In this case, the resulting precursor is a halide (chloride) of Ag, Au, Pt, Ta, Ti or W, and the thin film formed on the surface of the substrate 103 is that of Ag, Au, Pt, Ta, Ti or W.

Since the metal film production apparatus constructed as above uses the $Cl_2$ gas plasma (source gas plasma) 114, the reaction efficiency is markedly increased, and the speed of film formation is fast. Since the $Cl_2$ gas is used as the source gas, moreover, the cost can be markedly decreased. Furthermore, the substrate 103 is controlled to a lower temperature than the temperature of the copper plate member 107 by use of the temperature control means 106. Thus, the amounts of impurities, such as chlorine, remaining in the thin Cu film 116 can be decreased, so that a high quality thin Cu film 116 can be produced.

The metal film production apparatus of the present embodiment is equipped with control means 121 for gradually increasing the source gas from 0 to a predetermined flow rate (the flow rate at which ordinary film formation is carried out) at the start of film formation to increase the particle size of the metal component gradually. That is, the flow rate of the $Cl_2$ gas through the flow controller 113 is controlled by a command from the control means 121. Also, rare gas nozzles 122 are provided for supplying a rare gas (for example, He gas) at a predetermined flow rate at the start of film formation to generate an He gas plasma. An He gas is fed to the rare gas nozzle 122 through a flow controller 123 (rare gas supply means). A command from the control means 121 is inputted into the flow controller 123 to control the flow rate of the He gas through the flow controller 123.

That is, as indicated by a solid line in FIG. 11. the $Cl_2$ gas is controlled to be increased gradually and linearly from 0 at the start of film formation (time t0) to a predetermined flow rate (expressed as 100) (at time t1). Simultaneously, as indicated by a dashed line in FIG. 11, the He gas is controlled to be decreased gradually and linearly from 100 at the start of film formation (time t0) to 0 by the time t1. The time t1 is set at, for example, about 1 minute, although it depends on the flow rates of the gases and the time of completion of film formation (t2). The time for which the $Cl_2$ gas is increased to the predetermined flow rate can be set at and changed to an appropriate time. As described above, the gases are supplied such that the $Cl_2$ gas is gradually increased, and the He gas is simultaneously gradually decreased, at the start of film formation (t0). By this means, the total amount of the gases can be supplied as 100 from the start of film formation. Even when the $Cl_2$ gas is 0 at the start of film formation (t0), generation of plasma can be maintained. Thus, the $Cl_2$ gas can be

gradually increased continuously in a stable plasma state, with the total amount of the gases being kept constant.

Consequently, immediately after start of film formation, the generation of particles of the precursor, including etching particles, which inhibit adhesion, is suppressed and the Cu component with a small particle size is formed into a film. Then, the particle size of the Cu component gradually increases to a predetermined size. As a result, a Cu film with high adhesion can be prepared on the surface of the substrate.

That is, the $Cl_2$ gas is controlled to increase gradually from 0 to a predetermined flow rate (expressed as 100). By this means, immediately after start of film formation, particles of Cu with a small particle size (for example, 0.1 $\mu$m or less) are formed into a film by the precursor 115 having a small particle size, as shown in FIG. 12(a). Then, as shown in FIG. 12(b), Cu particles (for example, with a final size of about 0.5 $\mu$m) are gradually formed into a film by the precursor with a large particle size to appear as a thin Cu film 116.

Hence, Cu particles with a small particle size are formed into a film, and fine etching particles inhibiting adhesion are suppressed, at the initial stage of film formation, whereby film formation can be performed with improved adhesion.

Film formation was carried out, for example, under the following conditions: The barrier metal layer was tantalum nitride (TaN), the power area density of plasma was 2.2 w/cm$^2$, and the $Cl_2$ gas was gradually increased over about 1 minute to a predetermined flow rate (100). In this case, it was confirmed that particles of Cu with a small particle size (for example, 0.1 $\mu$m or less) were formed into a film at the initial stage, and then Cu particles with a large particle size (for example, with a final size of about 0.5 $\mu$m) were gradually formed into a film. To evaluate adhesion, a peeling test using an adhesive tape was conducted, thereby investigating the situation of peeling. This test confirmed that no peeling occurred. The reason why the particles of Cu finally reach, for example, about 0.5 $\mu$m is that the small particles inhibit each other's growth, restricting the final size of the particles to about 0.5 $\mu$m.

If the $Cl_2$ gas is supplied at a predetermined flow rate (100), starting at the initial stage of film formation, particles of Cu are formed into a film from the precursor 115 with a large particle size (for example, exceeding 1 $\mu$m), as shown in FIG. 12(c). Gaps may be formed between this film and the barrier metal layer, inhibiting adhesion. The $Cl_2$ gas was supplied at a predetermined flow rate (100), starting at the initial stage of film formation, and the resulting thin Cu film 116 was evaluated for adhesion by a peeling test using an adhesive tape. The peeling test confirmed peeling to occur at a rate of 100%.

A function of the gradual increase in the $Cl_2$ gas is optionally set by the material for the barrier metal layer or the metal to be formed into a film. If the metal to be formed into a film is Cu and the barrier metal layer is tantalum nitride (TaN), for example, the $Cl_2$ gas is increased linearly, as indicated by the solid line in FIG. 11. If the metal to be formed into a film is Cu and the barrier metal layer is tungsten nitride (WN), the $Cl_2$ gas is increased relatively quickly, as indicated by a one-dot chain line in FIG. 11, because tungsten has higher adhesion to Cu than does tantalum. If the metal to be formed into a film is Cu and the barrier metal layer is titanium nitride (TiN), the $Cl_2$ gas is increased relatively slowly, as indicated by a two-dot chain line in FIG. 11, because titanium has lower adhesion to Cu than does tantalum. In these manners, adhesion can be improved, regardless of the material for the barrier metal layer or the metal to be formed into a film. The control means 121 is adapted to change the function of the gradual increase in the $Cl_2$ gas according to differences among individual apparatuses and the conditions for film formation.

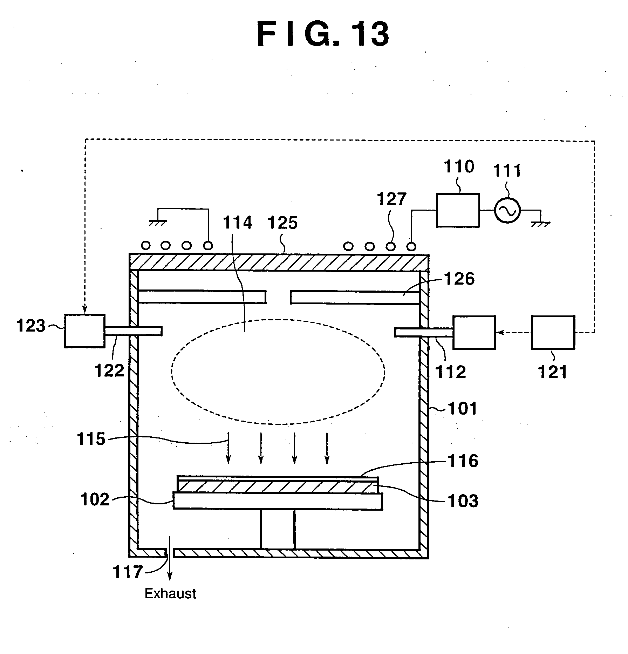

Seventh to ninth embodiments of the metal film production apparatus will be described with reference to FIGS. 13 to 15. With the metal film production apparatus illustrated below, similar to the previous one, the source gas containing chlorine, as a halogen, is supplied by control means 121 to the interior of a chamber 101 between a substrate and an etched member made of a metal (Cu) in such a manner as to be increased continuously and gradually from 0 to a predetermined flow rate, thereby increasing the particle size of the metal component (Cu component) gradually. Consequently, immediately after start of film formation, the generation of particles of the precursor, including etching particles, which inhibit adhesion, is suppressed and the Cu component with a small particle size is formed into a film. Then, the particle size of the Cu component gradually increases to a predetermined size. As a result, a Cu film with high adhesion can be prepared on the surface of the substrate.

FIGS. 13 to 15 show a schematic construction of the metal film production apparatus according to each of the seventh to ninth embodiments of the present invention. The same members as in the metal film production apparatus shown in FIG. 10 are assigned the same numerals, and duplicate explanations are omitted.

In the metal film production apparatus as the seventh embodiment shown in FIG. 13, an upper surface of the chamber 101 is an opening, which is closed with a disk-shaped ceiling board 125 made of an insulating material (for example, a ceramic). An etched member 126 made of a metal (copper, Cu) is interposed between the opening at the upper surface of the chamber 101 and the ceiling board 125. A plasma antenna 127, for converting the atmosphere inside the chamber 101 into a plasma, is provided above the ceiling board 125. The plasma antenna 127 is formed in a planar ring shape parallel to the surface of the ceiling board 125. A matching instrument 110 and a power source 111 are connected to the plasma antenna 127 to supply power.

The etched member 126 has a plurality of protrusions provided in the circumferential direction on the inner periphery of a ring portion, and includes notches (spaces) formed between the protrusions. Thus, the protrusions are arranged between the substrate 103 and the ceiling board 125 in a discontinuous state relative to the flowing direction of electricity in the plasma antenna 127.

With the above-described metal film production apparatus, the source gas is supplied through nozzles 112 to the interior of the chamber 101, and electromagnetic waves are shot from the plasma antenna 127 into the chamber 101. As a result, $Cl_2$ gas is ionized to generate a $Cl_2$ gas plasma (source gas plasma) 114. The etched member 126, an electric conductor, is present below the plasma antenna 127. However, the $Cl_2$ gas plasma 114 occurs stably between the etched member 126 and the substrate 103, namely, below the etched member 126, because the etched member 126 is disposed in a discontinuous state relative to the flowing direction of electricity in the plasma antenna 127.

With the metal film production apparatus shown in FIG. 13, even though the etched member 126, an electric conductor, exists below the plasma antenna 127, the electromagnetic waves are reliably thrown from the plasma antenna 127 into the chamber 101. Consequently, the $Cl_2$ gas plasma 114 can be stably generated below the etched member 126.

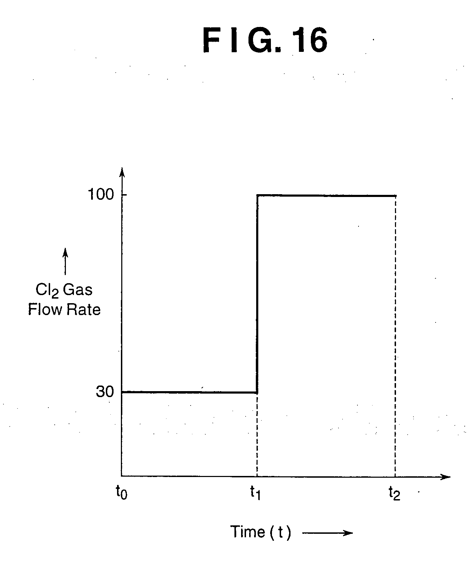

Compared with the metal film production apparatus shown in FIG. 10, the metal film production apparatus of the eighth embodiment shown in FIG. 16 is constructed such that the plasma antenna 109 is not provided around the cylindrical portion of the chamber 101, but the matching instrument 110 and power source 111 are connected to the copper plate member 107 for supply of power to the copper plate member 107.

The source gas is supplied from the nozzles 112 into the chamber 101, and electromagnetic waves are shot from the copper plate member 107 into the chamber 101, whereby the $Cl_2$ gas is ionized to generate a $Cl_2$ gas plasma (source gas plasma) 114. The $Cl_2$ gas plasma 114 causes an etching reaction to the copper plate member 107, forming a precursor 115. At this time, the copper plate member 107 is maintained at a temperature (e.g., 200 to 400°C), which is higher than the temperature of the substrate 103, by temperature control means (not shown).

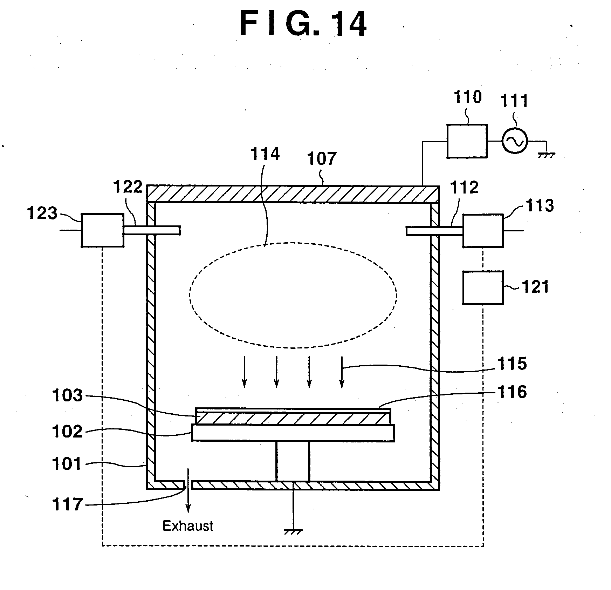

With the metal film production apparatus shown in FIG. 14, the copper plate member 107 itself is applied as an electrode for plasma generation. Thus, the plasma antenna 109 need not be provided around the cylindrical portion of the chamber 101, and the degree of freedom of the surrounding construction can be increased.

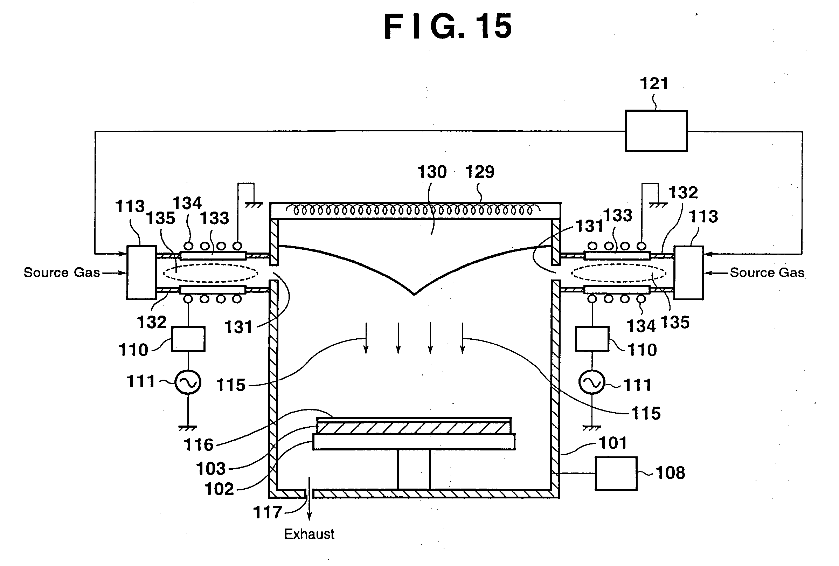

In the metal film production apparatus of the ninth embodiment shown in FIG. 15, the upper surface of the chamber 101 is an opening, and the opening is closed with a ceiling board 129, for example, made of a ceramic (an insulating material). An etched member 130 made of a metal (copper, Cu) is provided on a lower surface of the ceiling board 129, and the etched member 130 is of a quadrangular pyramidal shape. Slit-shaped opening portions 131 are formed in the periphery of the cylindrical portion of the chamber 101, and one end of a tubular passage 132 is fixed to each of the opening portions 131.

A tubular excitation chamber 133 made of an insulator is provided halfway through the passage 132, and a coiled plasma antenna 134 is provided around the excitation chamber 133. The plasma antenna 134 is connected to a matching instrument 110 and a power source 111 to receive power. A flow controller 113 is connected to the other end of the passage 132, and a source gas is supplied into the passage 132 via the flow controller 113.

By shooting electromagnetic waves from the plasma antenna 134 into the excitation chamber 133, the $Cl_2$ gas is ionized to generate a $Cl_2$ gas plasma (source gas plasma) 135. This means that the source gas is excited in the excitation chamber 133 isolated from the chamber 101. Because of the generation of the $Cl_2$ gas plasma 135, excited chlorine is fed into the chamber 101 through the opening portion 131, whereupon the etched member 130 is etched with excited chlorine.

The source gas is supplied into the passage 132 via the flow controller 113 and fed into the excitation chamber 133. By shooting electromagnetic waves from the plasma antenna 134 into the excitation chamber 133, the $Cl_2$ gas is ionized to generate a $Cl_2$ gas plasma (source gas plasma) 135. Since a predetermined differential pressure has been established between the pressure inside the chamber 101 and the pressure inside the excitation chamber 133 by the vacuum device 108, the excited chlorine of the $Cl_2$ gas plasma 135 in the excitation chamber 133 is fed to the etched member 130 inside the chamber 101 through the opening portion 131. The excited chlorine causes an etching reaction to the etched member 130, forming a precursor $(Cu_xCl_y)$ 115 inside the chamber 101.

With the metal film production apparatus shown in FIG. 15, the $Cl_2$ gas plasma 135 is generated in the excitation chamber 133 isolated from the chamber 101. Thus, the substrate 103 is not exposed to the plasma any more, and the substrate 103 becomes free from damage from the plasma. In the substrate 103 having a film of a different material formed during a preceding step, for example, the film of the material formed during the preceding step is free from damage. As the means for generating the $Cl_2$ gas plasma 135 in the excitation chamber 133 (excitation means), it is possible to use microwaves, laser, electron rays, or synchrotron radiation. The metal film production apparatus shown in FIG. 15 does not generate plasma within the chamber 101. Thus, there is no need to supply a rare gas in order to stabilize the plasma within the chamber 101.

Even with the above-described metal film production apparatus shown in each of FIGS. 13 to 15, immediately after start of film formation, the generation of particles of the precursor, including etching particles, which inhibit adhesion, is suppressed and the Cu component with a small particle size is formed into a film. Then, the particle size of the Cu component gradually increases to a predetermined size. As a result, a Cu film with high adhesion can be prepared on the surface of the substrate.

A third aspect of the present invention will now be described.

The third aspect comprises supplying a source gas containing chlorine, as a halogen, to the interior of a chamber between a substrate having a trench for wiring formation provided on a surface thereof and an etched member made of a metal (made of Cu) such that the source gas is increased in multiple stages (for example, two stages) to increase the particle size of a metallic component (Cu component) in two stages; converting an atmosphere within the chamber into a plasma to generate a chlorine gas plasma so that the copper plate member is etched with the chlorine gas plasma to form a precursor from the Cu component contained in the copper plate member and the chlorine gas; and making the temperature of the substrate lower than the temperature of the copper plate member to increase the particle size of the metallic component (Cu component) in two stages, thereby forming a film on the substrate.

According to this feature, immediately after start of film formation, the Cu component is formed as a film (buried) within the trench for wiring formation. Then, the particle size of the Cu component increases to a predetermined particle size, whereby a Cu film can be prepared on the surface of the substrate. In increasing the source gas in two stages, a rare gas (for example, an He gas) is supplied in such a manner as to be decreased in two stages according to the increase in the source gas. In this state, the plasma is generated. By so doing, the source gas can be increased in two stages in a stable plasma condition, with the total amount of gases being maintained at a constant level. The supply of the rare gas can be omitted.

In supplying the rare gas so as to be decreased according to the increase in the source gas, the diluent gas for the source gas can be used as the rare gas, and the rare gas and the source gas can be supplied simultaneously through a single nozzle via a mixing tank. In this case, the number of pipings may be small, so that the cost can be reduced. Alternatively, the supply lines for the source gas and the rare gas can be provided independently, so that the rare gas and the source gas can be supplied separately through the two lines. In this case, the amounts of the source gas and the rare gas supplied can be controlled easily.

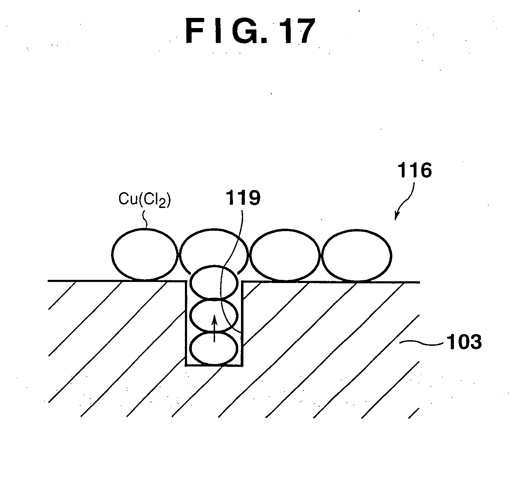

A tenth embodiment of a metal film production apparatus and a metal film production method according to the present invention will be described with reference to FIGS. 16 and 17. FIG. 16 shows the time course of the flow rate of the source gas in the metal film production apparatus according to the tenth embodiment of the invention. FIG. 17 shows the sectional situation of the surface of the substrate.

With the metal film production apparatus of the sixth embodiment, the control means 121 (see FIG. 10) gradually increases the source gas from 0 to a predetermined flow rate (the flow rate at which ordinary film formation is carried out) at the start of film formation to increase the particle size of the metal component gradually. According to the metal film production apparatus of the tenth embodiment, on the other hand, the control means 121 (see FIG. 10) increases the source gas in multiple stages (for example, two stages) to increase the particle size of the metal component (Cu component) in two stages. Other principles of film formation are the same as in the sixth embodiment. Thus, the drawing of the entire configuration is omitted.

The metal film production apparatus of the present embodiment is equipped with the control means 121 (see FIG. 10) for increasing the source gas in multiple stages (for example, two stages) at the start of film formation to increase the particle size of the metal component (Cu component) in two stages. That is, the flow rate of the $Cl_2$ gas through the flow controller 113 (see FIG. 10) is controlled by a command from the control means 121 (see FIG. 10). A command from the control means 121 (see FIG. 10) is inputted into the flow controller 123 (see FIG. 10) for the rare gas nozzle 122 (see FIG. 10) to control the flow rate of the He gas through the flow controller 123 in accordance with the increase in the source gas.

In detail, as shown in FIG. 16, the $Cl_2$ gas is supplied at a rate of 30 (between 20 and 40) relative to a predetermined flow rate (expressed as 100) from the start of film formation (time t0) until time t1. At the time t1, the $Cl_2$ gas is supplied at the predetermined flow rate (100), and is kept supplied at this predetermined flow rate until completion of film formation (time t2). By this procedure, the Cu component with a small particle size is formed into a film from the start of film formation until the time t1. From the time t1 onward, the particle size of the Cu component increases to a predetermined value.

As shown in FIG. 17, a trench 119 for wiring formation is provided on the surface of the substrate 103, and the trench 119 is set, for example, at a width of 0.2 μm and a dept of about 1 μm. If the $Cl_2$ gas is supplied at a predetermined flow rate (100) at the start of film formation (t0), particles of Cu are formed into a film from the precursor with a large particle size (for example, exceeding 1 μm) as stated earlier. In this case, there is a possibility that the particles will not arrive at the interior of the trench 119. By supplying the $Cl_2$ gas at a rate of 30 relative to the predetermined flow rate, particles of Cu with a small particle size are formed into a film within the trench 119 until the time t1, and these Cu particles with a small particle size grow upward in the trench 119.

With the metal film production apparatus of the present embodiment, chlorine radicals $Cl_{2*}$ with an etching action are existent concomitantly. In the trench 119 with a large area, therefore, its wall surface near its entrance is etched with chlorine radicals $Cl_{2*}$, and chlorine radicals $Cl_{2*}$ do not reach the deep site of the trench 119, with the result that only Cu with a small particle size is formed into the film within the trench 119. Thus, Cu with a small particle size is formed into the film within the trench 119 until the time t1, and Cu with a predetermined particle size is formed into a film on the surface of the substrate 103 from the time t1 until completion of film formation (time t2), to produce a thin Cu film 116.

The period from the start of film formation (t0) to the time t1 is set, for example, at 60 seconds, while the period from the time t1 to the completion of film formation at the time t2 is set, for example, at 60 seconds. The period of time for the rate of the amount of supply of the source gas is generally set at 1:1 relative to the entire period of time for film formation. However, it can be optionally changed according to the shape of the trench 119, the flow rate of the gas, the type of the gas, the plasma power, or the type of the barrier metal, and set as the rate to the period of time until completion of film formation.

As a result, only Cu with a small particle size is formed into a film within the trench 119 from the start of film formation to the time t1, and then the particle size of the Cu component increases to a predetermined particle size, whereby a Cu film can be prepared on the surface of the substrate. Hence, particles of Cu also reliably form the film within the trench 119. This makes it possible to carry out film formation while improving burial characteristics even for the substrate 103 having the trench 119 formed therein.

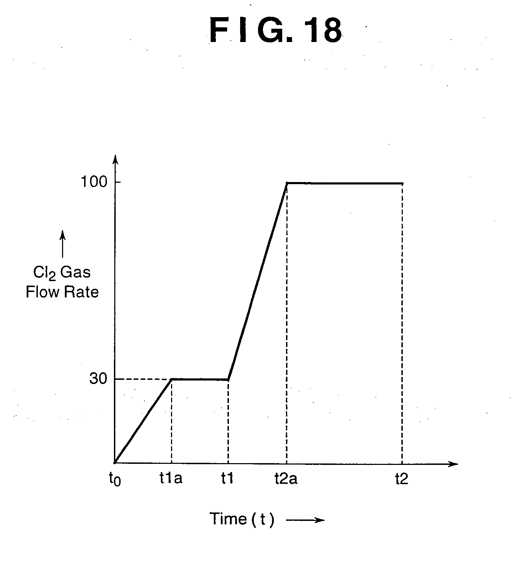

An eleventh embodiment of the present invention will be described. FIG. 18 shows the time course of the flow rate of the source gas for illustrating the eleventh embodiment of the present invention.

The illustrated metal film production apparatus of the present embodiment is designed to increase the source gas gradually at an initial stage of increasing (initial stage of supply) when increasing the source gas in multiple stages (for example, two stages) to increase the particle size of the metal component (Cu component) in two stages. Other constitutions, such as the principle of film formation, are the same as in the sixth embodiment. Thus, the drawing of the entire configuration is omitted.

The metal film production apparatus of the present embodiment is equipped with the control means 121 (see FIG. 10) for increasing the source gas in multiple stages (for example, two stages) at the start of film formation to increase the particle size of the metal component (Cu component) in two stages, and also for increasing the source gas gradually at start of each increase (at the initial stage of supply and at the initial stage of increasing). That is, the flow rate of the $Cl_2$ gas through the flow controller 113 (see FIG. 10) is controlled by a command from the control means 121 (see FIG. 10). A command from the control means 121 (see FIG. 10) is inputted into the flow controller 123 (see FIG. 10) of the rare gas nozzle 122 (see FIG. 10) to control the flow rate of the He gas through the flow controller 123 in accordance with the increase in the source gas.

In detail, as shown in FIG. 18, the $Cl_2$ gas is increased gradually from the start of film formation (t0) until time t1a in the initial stage of supply, and is supplied at a rate of 30 (between 20 and 40) relative to a predetermined flow rate (expressed as 100) from the time t1a until time t1. From the time t1 to time t2a in the initial stage of increasing, the $Cl_2$ gas is gradually increased from the rate of 30. From the time t2a onward, the $Cl_2$ gas is supplied at the predetermined flow rate (100), and is kept supplied at this predetermined flow rate until time t2 when film formation is completed. By this procedure, adhesion of the resulting film is improved at the initial phase of each stage as stated earlier. From the start of film formation until the time t1, the Cu component with a small particle size is formed into a film with satisfactory adhesion. From the time t2a onward, the particle size of the Cu component increases to a predetermined value.

According to the time course illustrated in FIG. 18, the period from the start of film formation (t0) to the time t1a is set, for example, at 30 seconds, the period from the time t1a to the time t1 is set, for example, at 60 seconds, the period from the time t1 to the time t2a is set, for example, at 30 seconds, and the period from the time t2a to the time t2, i.e. at completion of film formation, is set, for example, at 60 seconds. The period of time for the rate of the amount of supply of the source gas is set relative to the entire period of time for film formation. However, it can be optionally changed according to the shape of the trench 119, the flow rate of the gas, the type of the gas, the plasma power, or the type of the barrier metal, and set as the rate to the period of time until completion of film formation.

Thus, it becomes possible to perform film formation while achieving adhesion and burial characteristics at the same time.

The metal film production apparatus shown in each of FIGS. 13 to 15 can be applied to the tenth and eleventh embodiments described above.

The mechanism of film formation in each of the above-described embodiments is to etch copper with $Cl_2$ gas converted into a plasma. In the presence of a large amount of CuCl in the precursor 115, Cu contributing to film formation also stably deposits on the substrate 103. When the $Cl_2$ gas is converted into a plasma, chlorine radicals $(Cl_*)$ react with Cl within the chamber 101 to form $Cl_2$, or chlorine radicals $(Cl_*)$ react with CuCl to form $CuCl_2$. Moreover, chlorine radicals $(Cl_*)$ collide with each other and decrease. Because of these secondary reactions, as film formation proceeds, CuCl decreases, and film formation does not progress any more. Also, the phenomenon may arise that the thin Cu film 116, once formed, is etched with the resulting $Cl_2$ or

CuCl$_2$.

Thus, when the increase in CuCl peaks, the supply of the Cl$_2$ gas is stopped, and the chamber 101 is once evacuated to exhaust chlorine radicals (Cl$_*$). Then, Cl$_2$ gas is supplied anew, and converted into a plasma, namely, Cl$_2$ gas is supplied intermittently. By this means, the decrease in the amount of CuCl due to the secondary reactions and the etching reaction can be suppressed to curtail the decline in the efficiency of film formation. As a result, the thickness of the film formed can be increased relative to the total time taken for film formation, and the film formation speed can be increased.

For example, the plasma intensity of CuCl is detected, and the following control can be exercised: When the plasma intensity of CuCl begins to decrease, the supply of the Cl$_2$ gas is stopped, and the Cl$_2$ gas is exhausted. When the Cl plasma intensity has decreased upon discharge of chlorine radicals Cl$_*$, the supply of Cl$_2$ gas is resumed. Preferably, the situation of the time courses shown in FIGS. 11, 16 and 18 is divided at intervals of a predetermined time (for example, several tens of seconds), and Cl$_2$ gas is supplied in an intermittent manner (pulsed manner).

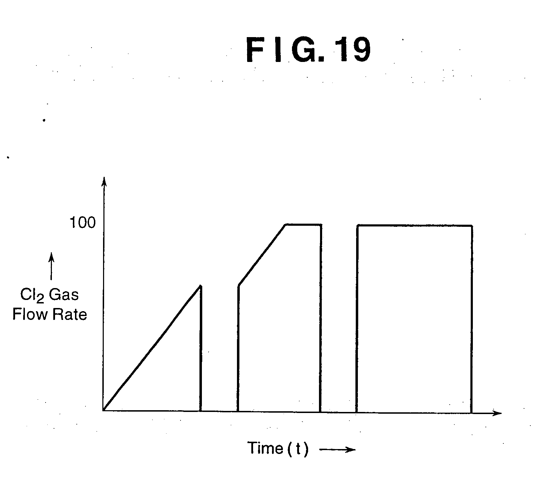

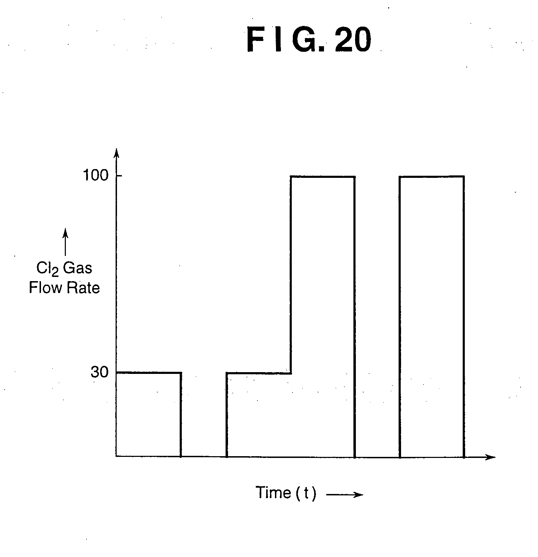

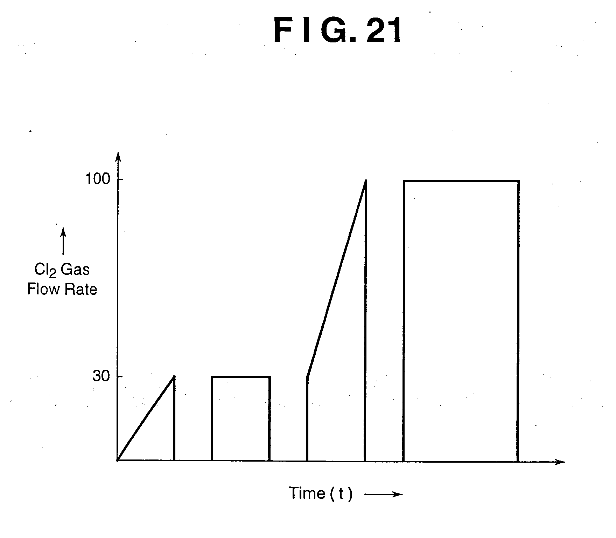

That is, the supply of Cl$_2$ gas shown in FIG. 11 can be divided unchanged, for example, into three portions as shown in FIG. 19, or the supply of Cl$_2$ gas shown in FIG. 16 can be divided unchanged, for example, into three portions as shown in FIG. 20, or the supply of Cl$_2$ gas shown in FIG. 18 can be divided unchanged, for example, into four portions as shown in FIG. 21. In such cases, in the individual supply portions, the plasma intensity of CuCl is controlled so as not to decrease, and the formation of Cl$_2$ or CuCl$_2$ is suppressed. Thus, the thin Cu film 116 of a predetermined thickness can be obtained, even if the total time is shortened.

While the present invention has been described in the foregoing fashion, it is to be understood that the invention is not limited thereby, but may be varied in many other ways.

**Claims**

1. A metal film production apparatus comprising:

   a chamber accommodating a substrate;
   a metallic etched member provided in the chamber at a position opposed to the substrate;
   source gas supply means for supplying a source gas containing a halogen;
   plasma generation means for generating a source gas plasma to etch the etched member, thereby forming a precursor from a metal component contained in the etched member and the source gas;
   temperature control means for making a temperature of the substrate lower than a temperature of the etched member to form the metal component of the precursor into a film on the substrate; and
   control means for suppressing a relative increase in etching particles by supplying the source gas intermittently.

2. The metal film production apparatus of claim 1, which further comprises rare gas supply means for supplying a rare gas to generate a rare gas plasma, and wherein the control means has a function of adjusting an amount of the rare gas according to supply of the source gas.

3. The metal film production apparatus of claim 1 or 2, which further comprises detection means for detecting plasma particles within the chamber, and wherein the control means has a function of controlling a supply state of the source gas based on a situation of the plasma particles detected by the detection means.

4. The metal film production apparatus of claim 1 or 2, wherein the control means has a function of controlling the source gas so as to be intermittently supplied in a preset state.

5. The metal film production apparatus of claim 4, wherein as the preset state in the control means, t/T, a relation between a period of time T for which the source gas is supplied, and a period of time t for which the source gas is not supplied, is set as follows:

$$0.03 \leq t/T \leq 0.10$$

6. The metal film production apparatus of any one of claims 1 to 5, wherein the control means is means for intermittently controlling supply of the source gas from the source gas supply means.

7. The metal film production apparatus of any one of claims 1 to 5, wherein the control means is means for controlling supply of the source gas so as to be in an intermittently, supplied manner by controlling a situation of exhaust from within the chamber.

8. The metal film production apparatus of any one of claims 1 to 7, wherein the source gas containing the halogen is the source gas containing chlorine.

9. The metal film production apparatus of claim 8, wherein the etched member is made of copper so that $Cu_xCl_y$ is formed as the precursor.

10. The metal film production apparatus of any one of claims 1 to 8, wherein the etched member is made of tantalum, tungsten or titanium which is a halide-forming metal.

11. A metal film production method comprising:

supplying a source gas containing a halogen to an interior of a chamber between a substrate and a metallic etched member such that the source gas is intermittently supplied to suppress a relative increase in etching particles; converting an atmosphere within the chamber into a plasma to generate a source gas plasma so that the etched member is etched with the source gas plasma to form a precursor from a metal component contained in the etched member and the source gas; and making a temperature of the substrate lower than a temperature of the etched member to form the metal component of the precursor into a film on the substrate, while suppressing the relative increase in the etching particles.

12. The metal film production method of claim 11, further comprising:

detecting plasma particles within the chamber; and controlling a supply state of the source gas based on a situation of the detected plasma particles to suppress the relative increase in the etching particles.

13. The metal film production method of claim 12, further comprising:

bringing the source gas into an unsupplied state when the plasma particles contributing to film formation begin to decrease after maximizing; and bringing the source gas into a supplied state when the etching particles come into a predetermined decreased state.

14. The metal film production method of claim 11, further comprising controlling the source gas so as to be intermittently supplied in a preset state, thereby suppressing the relative increase in the etching particles.

15. The metal film production method of claim 14, wherein t/T, a relation between a period of time T for which the source gas is supplied, and a period of time t for which the source gas is not supplied, is set as follows:

$$0.03 \leq t/T \leq 0.10$$

16. A metal film production apparatus comprising:

a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for gradually increasing the source gas from a flow rate of 0 to a predetermined flow rate during film formation, thereby gradually increasing a particle size of the metal component.

17. The metal film production apparatus of claim 16, wherein the control means has a function of gradually increasing the source gas continuously.

18. The metal film production apparatus of claim 17, which further comprises rare gas supply means for supplying a rare gas at a predetermined flow rate at start of film formation to generate a rare gas plasma, and wherein the control means has a function of gradually decreasing an amount of the rare gas in accordance with a gradual increase in the source gas in gradually increasing an amount of the source gas.

19. The metal film production apparatus of any one of claims 16 to 18, wherein the control means has a changing function of changing an increasing function according to a material for the substrate and the metal component formed into the film.

20. A metal film production apparatus comprising:

a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and

control means for increasing the source gas to a predetermined flow rate in multiple stages during film formation, thereby increasing a particle size of the metal component stepwise.

21. The metal film production apparatus of claim 20, which further comprises rare gas supply means for supplying a rare gas at a predetermined flow rate at start of film formation to generate a rare gas plasma, and wherein the control means has a function of decreasing an amount of the rare gas in multiple stages in accordance with an increase in the source gas in increasing an amount of the source gas in the multiple stages.

22. The metal film production apparatus of claim 20 or 21, wherein the substrate accommodated in the chamber is provided with a trench for wiring formation, and the control means has a function of supplying the source gas in such an amount that particles of the metal component are stacked in layers within the trench, and then increasing the amount of the source gas.

23. A metal film production apparatus comprising:

a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for increasing the source gas to a predetermined flow rate in multiple stages during film formation, thereby increasing a particle size of the metal component stepwise, and for gradually increasing the source gas at start of each increase, thereby gradually increasing the particle size of the metal component.

24. A metal film production apparatus comprising:

a chamber accommodating a substrate; a metallic etched member provided in the chamber at a position opposed to the substrate; source gas supply means for supplying a source gas containing a halogen;

plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for gradually increasing the source gas to a predetermined flow rate during film formation, thereby gradually increasing a particle size of the metal component, and for intermittently supplying the source gas, thereby suppressing a relative increase in etching particles;

25. A metal film production apparatus comprising:

a chamber accommodating a substrate; a metallic etched member provided in the chamber at a position opposed to the substrate; source gas supply means for supplying a source gas containing a halogen; plasma generation means for generating a source gas plasma to etch the etched member, thereby forming a precursor from a metal component contained in the etched member and the source gas; temperature control means for making a temperature of the substrate lower than a temperature of the etched member to form the metal component of the precursor into a film on the substrate; and control means for increasing the source gas to a predetermined flow rate in multiple stages during film formation, thereby increasing a particle size of the metal component stepwise, also for gradually increasing the source gas at start of increase, thereby gradually increasing the particle size of the metal component, and further for intermittently supplying the source gas, thereby suppressing a relative increase in etching particles.

26. A metal film production method comprising:

supplying a source gas containing a halogen to an interior of a chamber between a substrate and a metallic etched member such that the source gas is gradually increased from a flow rate of 0 to a predetermined flow rate to increase a particle size of a metal component gradually; converting an atmosphere within the chamber into a plasma to generate a source gas plasma so that the etched member is etched with the source gas plasma to form a precursor from the metal component contained in the etched member and the source gas; and

making a temperature of the substrate lower than a temperature of the etched member to form the metal component of the precursor into a film on the substrate, while gradually increasing the particle size of the metal component.

**27.** A metal film production method comprising:

supplying a source gas containing a halogen to an interior of a chamber between a substrate and a metallic etched member such that the source gas is increased to a predetermined flow rate in multiple stages to increase a particle size of a metal component stepwise; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while increasing the particle size of the metal component stepwise.

**28.** The metal film production method of claim 27, wherein when the source gas is increased to the predetermined flow rate in the multiple stages, the source gas is supplied in such an amount that particles of the metal component are stacked in layers within a trench for wiring formation provided in the substrate, and then the amount of the source gas is increased.

**29.** A metal film production method comprising:

supplying a source gas containing a halogen to an interior of a chamber between a substrate and a metallic etched member such that the source gas is increased to a predetermined flow rate in multiple stages to increase a particle size of a metal component stepwise, and such that the source gas is gradually increased at start of each increase to increase the particle size of the metal component gradually; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while increasing the particle size stepwise, and also increasing the particle size gradually.

**30.** A metal film production method comprising:

supplying a source gas containing a halogen to an interior of a chamber between a substrate and a metallic etched member such that the source gas is gradually increased from a flow rate of 0 to a predetermined flow rate to increase a particle size of a metal component gradually, and such that the source gas is intermittently supplied to suppress a relative increase in etching particles; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to increase the particle size gradually and form the metal component of the precursor into a film on the substrate, while increasing the particle size gradually.

**31.** A metal film production method comprising:

supplying a source gas containing a halogen to an interior of a chamber between a substrate and a metallic etched member such that the source gas is increased to a predetermined flow rate in multiple stages to increase a particle size of a metal component stepwise, also such that the source gas is gradually increased at start of each increase to increase the particle size of the metal component gradually, and further such that the source gas is intermittently supplied to suppress a relative increase in etching particles; converting an atmosphere within the chamber into a plasma to generate a source gas plasma so that the etched member is etched with the source gas plasma to form a precursor from the metal component contained in the etched member and the source gas; and making a temperature of the substrate lower than a temperature of the etched member to form the metal component of the precursor into a film on the substrate, while increasing the particle size stepwise, also increasing the particle size gradually, and also suppressing the relative increase in the etching particles.

**32.** The metal film production method of any one of claims 11 to 31, wherein the source gas containing the halogen is the source gas containing chlorine.

33. The metal film production method of claim 32, wherein the etched member is made of copper so that $Cu_xCl_y$ is formed as the precursor.

34. The metal film production method of any one of claims 11 to 32, wherein the etched member is made of tantalum, tungsten or titanium which is a halide-forming metal.

# FIG. 1

Pare Gas

23

22

10

11

14   7

13

Source Gas

12

9

24

15

16

1

2

17

18

4

3

Refrigerant

5

8

6

21

# F I G. 2

# FIG. 3

Cl$_2$ Gas
Flow Rate

T

t

Time

# FIG. 4

Film Thickness

Time

# FIG. 5

**37**

| Pulse Generation Function | **38** |
| Setting Function | **39** |

Flow Controller 13
Flow Controller 23

# FIG. 6

Exhaust

# FIG. 7

Exhaust

# FIG.8

# F I G. 9

# FIG. 10

Rare Gas

Source Gas

Exhaust

Refrigerant

# F I G. 11

# F I G. 12

( a )          ( b )          ( c )

# F I G. 13

# F I G. 14

# FIG. 15

EP 1 338 674 A1

# F I G. 16

Cl₂ Gas Flow Rate

100

30

t₀    t₁    t₂

Time ( t )

# F I G. 17

Cu(Cl₂)    **119**    **116**

**103**

# FIG. 18

# F I G. 19

# F I G. 20

EP 1 338 674 A1

# FIG. 21

Cl$_2$ Gas
Flow Rate

100

30

Time ( t )

43

## EUROPEAN SEARCH REPORT

**European Patent Office**

Application Number

EP 03 00 2047

### DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| E | EP 1 284 305 A (MITSUBISHI HEAVY IND LTD) 19 February 2003 (2003-02-19)<br><br>* column 3, line 22-58 *<br>* column 4, line 8-12,47-56 *<br>* column 7, line 27-47 *<br>* column 8, line 2-6,42-51 *<br>* figures 1,2 *<br>--- | 1,2,4,6, 8,9,11, 16-25 | C23C16/14 C23C16/448 C23C16/52 |
| X | PATENT ABSTRACTS OF JAPAN vol. 2002, no. 02, 2 April 2002 (2002-04-02) & JP 2001 295046 A (MITSUBISHI HEAVY IND LTD), 26 October 2001 (2001-10-26) * abstract *<br>--- | 1,2,4,6, 8,9,11, 16-25 | |
| Y | WO 01 73159 A (NISHIMORI TOSHIHIKO ;ABE TAKAO (JP); GOYA SANEYUKI (JP); UEDA NORI) 4 October 2001 (2001-10-04) * the whole document * | 1,2,4,6, 8,9,11, 16-25 | |
| Y,P | & EP 1 199 378 A (MITSUBISHI HEAVY IND LTD) 24 April 2002 (2002-04-24)<br><br>* column 20, line 33 - column 21, line 50; figure 1 *<br>* column 26, line 48 - column 27, line 32; figure 10 *<br>--- | 1,2,4,6, 8,9,11, 16-25 | TECHNICAL FIELDS SEARCHED (Int.Cl.7)<br><br>C23C |
| Y | WO 91 17284 A (IBM) 14 November 1991 (1991-11-14)<br><br>* page 5, line 29-34 *<br>* page 6, line 12-31 *<br>* figure 1 *<br>----- | 1,2,4,6, 8,9,11, 16-25 | |

The present search report has been drawn up for all claims

| Place of search | Date of completion of the search | Examiner |
|---|---|---|
| MUNICH | 14 May 2003 | Joffreau, P-O |

## ANNEX TO THE EUROPEAN SEARCH REPORT
## ON EUROPEAN PATENT APPLICATION NO.

EP 03 00 2047

This annex lists the patent family members relating to the patent documents cited in the above-mentioned European search report.
The members are as contained in the European Patent Office EDP file on
The European Patent Office is in no way liable for these particulars which are merely given for the purpose of information.

14-05-2003

| Patent document cited in search report | | | Publication date | Patent family member(s) | | Publication date |
|---|---|---|---|---|---|---|
| EP 1284305 | A | | 19-02-2003 | EP 1284305 A2 | | 19-02-2003 |
| | | | | US 2003031791 A1 | | 13-02-2003 |
| JP 2001295046 | A | | 26-10-2001 | EP 1199378 A1 | | 24-04-2002 |
| | | | | WO 0173159 A1 | | 04-10-2001 |
| | | | | US 2002142572 A1 | | 03-10-2002 |
| WO 0173159 | A | | 04-10-2001 | JP 2001295046 A | | 26-10-2001 |
| | | | | JP 2001335933 A | | 07-12-2001 |
| | | | | JP 2001342564 A | | 14-12-2001 |
| | | | | EP 1199378 A1 | | 24-04-2002 |
| | | | | WO 0173159 A1 | | 04-10-2001 |
| | | | | US 2002142572 A1 | | 03-10-2002 |
| WO 9117284 | A | | 14-11-1991 | EP 0528795 A1 | | 03-03-1993 |
| | | | | JP 5504790 T | | 22-07-1993 |
| | | | | WO 9117284 A1 | | 14-11-1991 |
| | | | | US 5312509 A | | 17-05-1994 |

EPO FORM P0459

For more details about this annex : see Official Journal of the European Patent Office, No. 12/82